(19) Europäisches Patentamt
European Patent Office
Office européen des brevets

(11) **EP 4 610 747 A1**

(12) **EUROPEAN PATENT APPLICATION**

(43) Date of publication:
**03.09.2025 Bulletin 2025/36**

(51) International Patent Classification (IPC):
**G05B 13/02** (2006.01)    **G05B 17/02** (2006.01)

(21) Application number: **25159118.6**

(52) Cooperative Patent Classification (CPC):
**G05B 13/0265; G05B 17/02**

(22) Date of filing: **20.02.2025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.02.2024 JP 2024030163**

(71) Applicant: **Yokogawa Electric Corporation Tokyo 180-8750 (JP)**

(72) Inventor: **ISHII, Masaki Musashino-shi, Tokyo, 180-8750, (JP)**

(74) Representative: **Winter, Brandl - Partnerschaft mbB Alois-Steinecker-Straße 22 85354 Freising (DE)**

(54) **INFORMATION PROVIDING APPARATUS, INFORMATION PROVIDING METHOD, AND INFORMATION PROVIDING PROGRAM**

(57) A server device (10) generates N simulation models on the basis of operational data collected from a system, determines a simulation model in which a simulation model evaluation value for evaluating the simulation model is a maximum value on the basis of the operational data, generates M AI control models on the basis of the operational data and the determined simulation model, and determines the AI control model in which an AI control model evaluation value for evaluating the AI control model is a maximum value on the basis of the operational data.

## FIG.1

**Description**

FIELD

The present invention relates an information providing apparatus, an information providing method, and an information providing program.

BACKGROUND

In a case where artificial intelligence (AI) control is introduced to processes performed in a plant, there is a known AI control introduction effect report that is used to verify in advance whether the AI control is to be introduced and verify in advance an effect of the AI control.

Patent Document 1: Japanese Laid-open Patent Publication No. 2023-042919

However, it is difficult to easily verify the effect of the AI control that is to be introduced to a system, such as a plant. For example, in a case where an AI control introduction effect report about the processes performed in the plant is generated, there is a need to generate the AI control introduction effect report needs by a skilled engineer adjusting set parameters after having manually generated a plant simulator model, adjusting the set parameters after having generated the AI control model, and using both of the generated plant simulator model and the generated AI control model.

Accordingly, the present invention has been conceived in light of the circumstances described above and an object thereof is to easily verify an effect of AI control to be introduced to a system.

SUMMARY

According to an aspect of the embodiments, an information providing apparatus includes a first generation unit that generates, based on operational data collected from a system, a plurality of first models each of which outputs prediction data on an operational status of the system in accordance with an input of the operational data, a first evaluation unit that determines, based on the operational data, the first model in which a first evaluation value for evaluating the first model is a maximum value, a second generation unit that generates, based on the operational data and the determined first model, a plurality of second models each of which outputs control data related to control of the system in accordance with an input of the operational data, and a second evaluation unit that determines, based on the operational data, the second model in which a second evaluation value for evaluating the second model is a maximum value.

According to an aspect of the embodiments, an information providing method that causes a computer to execute a process includes generating, based on operational data collected from a system, a plurality of first models each of which outputs prediction data on an operational status of the system in accordance with an input of the operational data, determining, based on the operational data, the first model in which a first evaluation value for evaluating the first model is a maximum value, generating, based on the operational data and the determined first model, a plurality of second models each of which outputs control data related to control of the system in accordance with an input of the operational data, and determining, based on the operational data, the second model in which a second evaluation value for evaluating the second model is a maximum value.

According to an aspect of the embodiments, an information providing program that causes a computer to execute a process includes generating, based on operational data collected from a system, a plurality of first models each of which outputs prediction data on an operational status of the system in accordance with an input of the operational data, determining, based on the operational data, the first model in which a first evaluation value for evaluating the first model is a maximum value, generating, based on the operational data and the determined first model, a plurality of second models each of which outputs control data related to control of the system in accordance with an input of the operational data, and determining, based on the operational data, the second model in which a second evaluation value for evaluating the second model is a maximum value.

BRIEF DESCRIPTION OF THE DRAWINGS

FIG. 1 is a diagram illustrating a configuration example and a process example of an effect report providing system according to an embodiment;
FIG. 2 is a block diagram illustrating a configuration example of each device included in the effect report providing system according to the embodiment;
FIG. 3 is a block diagram illustrating an example of overall processes performed in the effect report providing system according to the embodiment;

FIG. 4 is a diagram illustrating one example of a first set value storage unit included in a server device according to the embodiment;

FIG. 5 is a diagram illustrating one example of a first model storage unit included in the server device according to the embodiment;

FIG. 6 is a diagram illustrating one example of a second set value storage unit included in the server device according to the embodiment;

FIG. 7 is a diagram illustrating one example of a second model storage unit included in the server device according to the embodiment;

FIG. 8 is a diagram illustrating one example of an effect report storage unit included in the server device according to the embodiment;

FIG. 9 is a diagram illustrating one example of a training data storage unit included in an operator terminal according to the embodiment;

FIG. 10 is a diagram illustrating one example of an evaluation data storage unit included in the operator terminal according to the embodiment;

FIG. 11 is a diagram illustrating one example of a definition information storage unit included in the operator terminal according to the embodiment;

FIG. 12 is a diagram illustrating a first specific example of a display screen displayed on an operator terminal according to the embodiment;

FIG. 13 is a second specific example of a display screen displayed on the operator terminal according to the embodiment;

FIG. 14 is a flowchart illustrating one example of an overall flow of the effect report providing system according to the embodiment;

FIG. 15 is a flowchart illustrating one example of the flow of a simulation model generation management process performed in the effect report providing system according to the embodiment;

FIG. 16 is a flowchart illustrating one example of the flow of an AI control model generation management process performed in the effect report providing system according to the embodiment;

FIG. 17 is a flowchart illustrating one example of the flow of an AI control introduction effect report generation management process performed in the effect report providing system according to the embodiment; and

FIG. 18 is a diagram illustrating an example of a hardware configuration according to the embodiment.

DETAILED DESCRIPTION OF THE PREFERRED EMBODIMENTS

In the following, preferred embodiments of an information providing apparatus, an information providing method, and an information providing program according to the present invention will be explained in detail below with reference to the accompanying drawings. Furthermore, the present invention is not limited to the embodiments described below.

In the following, a configuration and a process related to an effect report providing system 100 according to an embodiment, a configuration and a process related to each device included in the effect report providing system 100, the flow of the process performed in the effect report providing system 100, effects of the embodiment, and applications of the embodiment will be described.

1. Configuration and process related to effect report providing system 100

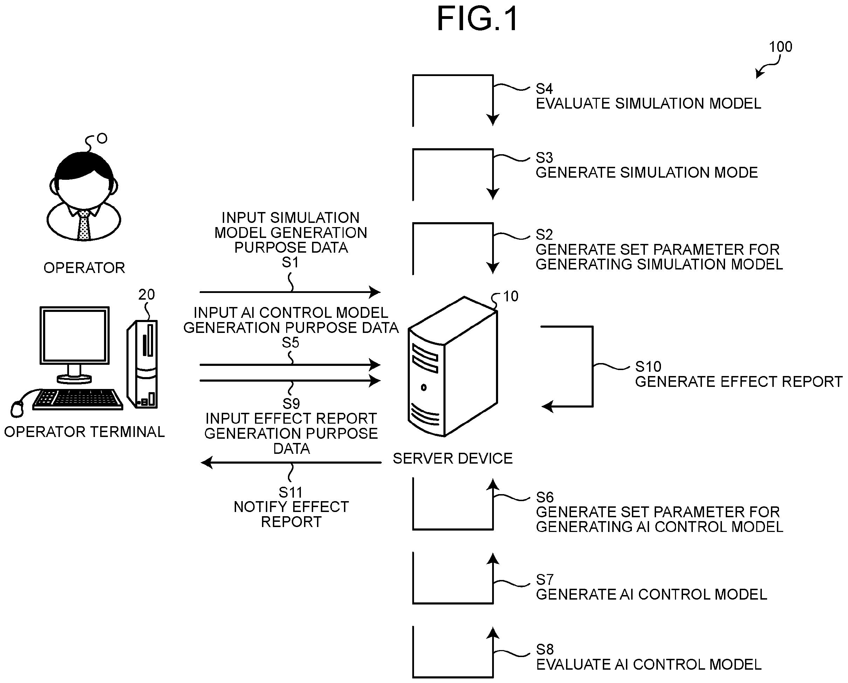

A configuration and a process related to the effect report providing system 100 according to the embodiment will be described in detail with reference to FIG. 1. FIG. 1 is a diagram illustrating a configuration example and a process example of the effect report providing system 100 according to the embodiment. In a description below, an example of the overall configuration of the effect report providing system 100, a process example of the effect report providing system 100, and the effects of the effect report providing system 100 will be described. Furthermore, in the embodiment, a description will be given by using generation of an AI control introduction effect report related to a plant as one example, but the example is not intended to limit fields of application. For example, the example may also be used for air-conditioning control of a convenience store, a supermarket, or the like.

1-1. Example of overall configuration of effect report providing system 100

The effect report providing system 100 includes a server device 10 and an operator terminal 20. Here, the server device 10 and the operator terminal 20 are connected to one another via a predetermined communication network (not illustrated) so as to be able to communicate each other in a wired or wireless manner. Furthermore, various kinds of communication networks, such as the Internet or a dedicated line, may be used for the predetermined communication network.

1-1-1. Server device 10

The server device 10 is an information providing apparatus that generates a simulation model SM and an AI control model CM, and that generates an AI control model introduction effect report (hereinafter, appropriately and simply referred to as an "effect report"). For example, the server device 10 is implemented by a cloud environment, an on-premise environment, an edge environment, or the like. Furthermore, two or more of the server devices 10 may be included in the effect report providing system 100 illustrated in FIG. 1.

1-1-2. Operator terminal 20

The operator terminal 20 is an administrator terminal that is used by an operator O who is an administrator of the plant. Furthermore, two or more of the operator terminals 20 may be included in the effect report providing system 100 illustrated in FIG. 1.

1-2. Example of overall process performed in effect report providing system 100

The overall process performed in the effect report providing system 100 described above. Furthermore, the processes performed at Steps S1 to S11 may be performed in different order. Moreover, some of the processes performed at Steps S1 to S11 described below may be omitted.

1-2-1. Simulation model generation purpose data input process

At a first step, the operator O inputs simulation model generation purpose data to the server device 10 via the operator terminal 20 (Step S1). For example, the operator O transmits, to the server device 10 by operating the operator terminal 20, operational data that is obtained in the plant, that is stored by the operator terminal 20, and that corresponds to training data and evaluation data to be input to a simulation model SM (hereinafter, appropriately referred to as a "first model").

Here, the simulation model SM is a machine learning model that has a function capable of dynamically predicting a subsequent state of a process targeted for control on the basis of the previous state and an operation performed on the process, and that outputs, for example, prediction data on an operational status of the plant in accordance with an input of pieces of operational data collected from the plant.

Furthermore, the operational data is time series data that indicates process values of the respective processes collected from the system, such as the plant, and is a data set in which, for example, a sensor value related to a temperature, a pressure, or the like indicating a state of a process is associated with an operation value related to a degree of opening of a valve, or the like indicating an operation performed on the process.

Furthermore, the operator O transmits, to the server device 10 by operating the operator terminal 20, simulation model generation purpose input/output definition information (hereinafter, appropriately referred to as "first definition information") that is stored in the operator terminal 20.

Here, the simulation model generation purpose input/output definition information is a set value for defining input data and output data to and from the simulation model SM, and is, for example, an input tag that is a name or an identifier of a process value that is related to the control valve or the like and that changes the state of the process, an output tag that is a name or an identifier of a process value that is related to a temperature, a pressure, or the like and that indicates the state of the process, or a delay time between an input and an output of data indicating a period of time until the output data is changed in a case where the input data has been changed.

1-2-2. Simulation model generation purpose set parameter creation process

At a second step, the server device 10 generates a simulation model generation purpose set parameter (hereinafter, appropriately referred to as a "first set value") (Step S2). For example, the server device 10 generates N patterns of simulation model generation purpose set parameters on the basis of a grid search.

Here, the simulation model generation purpose set parameters are candidates for hyperparameters for the simulation models SM, and are candidates for internal parameters that are used to generate the simulation models SM used in, for example, the system, such as the plant.

1-2-3. Simulation model generation process

At a third step, the server device 10 generates a simulation model SM (Step S3). For example, the server device 10 generates N simulation models SM by inputting a data set of a sensor value and an operation value of the plant as training data to each of the simulation models SM, inputting the N patterns of the simulation model generation purpose set parameters to the simulation models SM, and inputting the simulation model generation purpose input/output definition information to the simulation models SM.

1-2-4. Simulation model evaluation process

At a fourth step, the server device 10 evaluates the simulation models SM (Step S4). For example, the server device 10 inputs the data set of the sensor value and the operation value obtained in the plant as evaluation data to each of the simulation models SM, and calculates a simulation model evaluation value (hereinafter, appropriately referred to as a "first evaluation value"). At this time, the server device 10 calculates, as the simulation model evaluation value, a match rate between, for example, the sensor values collected in the plant and the sensor values that are output as the prediction data, and determines the simulation model SM having the maximum match rate from among the N simulation models SM that are generated at the process performed at Step S3 as the best simulation model SM (Best) that indicates the best performance.

1-2-5. AI control model generation purpose data input process

At a fifth step, the operator O inputs the AI control model generation purpose data to the server device 10 via the operator terminal 20 (Step S5). For example, the operator O transmits, to the server device 10 by operating the operator terminal 20, the operational data that is obtained in the plant, that is stored by the operator terminal 20, and that corresponds to the training data and the evaluation data to be input to an AI control model CM (hereinafter, appropriately referred to as a "second model").

Here, the AI control model CM is a machine learning model that has a function capable of dynamically operating a process corresponding targeted for control from the previous state to a subsequent state, and that outputs, for example, control data related to the plant in accordance with an input of pieces of operational data collected from the plant. Furthermore, the control data is, for example, a control instruction that indicates an operation to be instructed to the operator O or a worker in the plant, or a control signal that indicates an operation to be operated by an actuator.

Furthermore, the operator O transmits, to the server device 10 by operating the operator terminal 20, AI control model generation purpose input/output definition information (hereinafter, appropriately referred to as "second definition information") that is stored by the operator terminal 20.

Here, the AI control model generation purpose input/output definition information is a set value for defining the input data and the output data to and from the AI control model CM, and is, for example, an observation tag that is a name or an identifier of a process value that is related to a temperature, a pressure, or the like and that is observed at the time of operation of the AI control model CM, a control tag that is a name or an identifier of a process value that is related to a control valve, or the like and that is operated by the AI control model CM, or an operation cycle that is used when control is performed.

1-2-6. AI control model generation purpose set parameter creation process

At a sixth step, the server device 10 generates an AI control model generation purpose set parameter (hereinafter, appropriately referred to as a "second set value") (Step S6). For example, the server device 10 generates M patterns of simulation model generation purpose set parameters on the basis of a grid search.

Here, the AI control model generation purpose set parameters are candidates for hyperparameters for the AI control model CM, and are candidates for internal parameters that are used to generate the AI control model CM used in, for example, the system, such as the plant.

1-2-7. AI control model generation process

At a seventh step, the server device 10 generates an AI control model CM (Step S7). For example, the server device 10 generates M AI control models CM by inputting the data set of the sensor value and the operation value of the plant as the training data to the AI control models CM, inputting the M patterns of AI control model generation purpose set parameters to the AI control models CM, inputting the AI control model generation purpose input/output definition information to the AI control models CM, and using the best simulation model SM (Best) that indicates the best performance determined at the process performed at Step S4.

1-2-8. AI control model evaluation process

At an eighth step, the server device 10 evaluates the AI control models CM (Step S8). For example, the server device 10 inputs the data set of the sensor value and the operation value obtained in the plant as evaluation data to each of the AI control models CM, and calculates an AI control model evaluation value (hereinafter, appropriately referred to as a "second evaluation value"). At this time, the server device 10 calculates, by using a reward function as the AI control model evaluation value, reward values each of which is indicated when, for example, the process performed in the plant is controlled, and determines the AI control model CM having the maximum reward value from among the M simulation models SM that are generated at the process performed at Step S7 as the best AI control model CM (Best) that indicates the best performance.

1-2-9. AI control introduction effect report generation purpose data input process

At a ninth step, the operator O inputs the AI control introduction effect report generation purpose data to the server device 10 via the operator terminal 20 (Step S9). For example, the operator O transmits, to the server device 10 by operating the operator terminal 20, the operational data that is obtained in the plant, that is stored by the operator terminal 20, and that corresponds to the evaluation data that is used to generate the AI control introduction effect report.

Here, the AI control introduction effect report is a report that indicates the effect indicated when the AI control model CM has been introduced to the system, and that has been visualized by a graph, or the like in which, for example, a sensor value indicated in a case where the AI control model CM is not introduced to the plant is compared with a sensor value indicated in a case where the AI control model CM is to be introduced.

1-2-10. AI control introduction effect report generation process

At a tenth step, the server device 10 generates an AI control introduction effect report (Step S10). For example, the server device 10 generates the AI control introduction effect report in which a bar graph that indicates an average value of the sensor values and the standard deviation that are output by inputting past operation values related to the process performed in the plant to the best simulation model SM (Best) and a bar graph that indicates an average value of the sensor values and the standard deviation that are output by inputting the control data that is output from the best AI control model CM (Best) to the best simulation model SM (Best) are displayed side by side. Furthermore, the server device 10 generates an AI control introduction effect report in which a time series graph that indicates a time series variation in the sensor values that have been output by inputting past operation values related to the process performed in the plant to the best simulation model SM (Best) and a time series graph that indicates a time series variation in the sensor values that have been output by inputting the control data that is output from the best AI control model CM (Best) to the best simulation model SM (Best) are displayed in a superimposed manner.

1-2-11. AI control introduction effect report notification process

At an eleventh step, the server device 10 notifies the operator O of the AI control introduction effect report (Step S11). For example, the server device 10 transmits the generated AI control introduction effect report to the operator terminal 20, and causes the monitor of the operator terminal 20 to display the bar graphs or the time series graphs.

1-2-12. Others

In the effect report providing system 100, the AI control model CM is also used at the time of introduction to an actual site of the plant, in addition to generation of the AI control introduction effect report. Accordingly, from among the processes performed at Steps S1 to S11 described above, it is also possible to omit the process of performing the AI control introduction effect report generation process at Step S10, and the process of performing the AI control introduction effect report notification process at Step S11.

1-3. Effect of effect report providing system 100

In the following, the outline and problems in an effect report providing system 100P according to a reference technology will be described, and then, the effects of the effect report providing system 100 will be described.

1-3-1. Outline of effect report providing system 100P

The effect report providing system 100P according to the reference technology generates, in a case where AI control is introduced to the process performed in a plant, an AI control introduction effect report that is used to verify in advance whether AI control is to be introduced and verify in advance an effect of the AI control. In the following, a simulation model creation process, an AI control model creation process, and an AI control introduction effect report creation process performed by the effect report providing system 100P will be described.

1-3-1-1. Simulation model creation process

An engineer generates a simulation model SM by inputting training data, evaluation data, and a simulation model set parameter to a simulation model generator. At this time, the accuracy of the simulation model SM is evaluated by comparing the actual operational data with the simulation data. Furthermore, the engineer generates the simulation model SM having high prediction accuracy by manually adjusting the simulation model set parameter.

1-3-1-2. AI control model creation process

The engineer generates an AI control model CM by inputting the training data, the evaluation data, the simulation model SM, and an AI control model set parameter to an AI control model generator. At this time, the AI control model is generated as a result of an algorithm of the AI control model CM using the technology of reinforcement learning and AI itself learning a measure to obtain a maximum reward value by trial and error. The engineer generates a model having high control performance by manually adjusting the AI control model set parameter.

1-3-1-3. AI control introduction effect report creation process

The engineer generates an AI control introduction effect report by using the simulation model SM and the AI control model CM that are generated by the above described processes. At this time, the engineer compares the simulation data output from the simulation model SM with the control data output from the AI control model CM, and generates the degree of effect of the introduction of the AI control model CM as an AI control introduction effect report.

1-3-2. Problems in effect report providing system 100P

In the effect report providing system 100P according to the reference technology, there is a problem in that, in order to generate the AI control introduction effect report, there is a need to manually create complex system design and make model adjustment by an engineer who has a thorough knowledge of simulation models SM and AI control models CM used in a plant. Furthermore, in the effect report providing system 100P, there is a problem in that, in order to generate the AI control introduction effect report, the cost is increased and time is required.

1-3-3. Outline of effect report providing system 100

In the effect report providing system 100, the following process is performed. In the following, a simulation model generation management process, an AI control model generation management process, and an AI control introduction effect report generation management process that are performed by the effect report providing system 100 will be described.

1-3-3-1. Simulation model generation management process

In the effect report providing system 100, the following simulation model generation management process is performed. At a first step, the operator O inputs the simulation model generation purpose data to the server device 10 via the operator terminal 20. At a second step, the server device 10 generates N patterns of the simulation model generation purpose set parameters on the basis of a grid search. At a third step, the server device 10 uses the simulation model generation purpose data and N patterns of the simulation model generation purpose set parameters, and generates the N simulation models SM. At a fourth step, the server device 10 evaluates the N simulation models SM by using a match rate, and determines the best simulation model SM (Best) from among the N simulation models SM.

1-3-3-2. AI control model generation management process

In the effect report providing system 100, the following AI control model generation management process is performed. At a first step, the operator O inputs the AI control model generation purpose data to the server device 10 via the operator terminal 20. At a second step, the server device 10 generates M patterns of the AI control model generation purpose set parameters on the basis of the grid search. At a third step, the server device 10 uses the AI control model generation purpose data and M patterns of the AI control model generation purpose set parameters, and generates the M AI control models CM. At a fourth step, the server device 10 evaluates the AI control models CM by using the reward values, and determines the best AI control model CM (Best) from among the M simulation models SM.

1-3-3-3. AI control introduction effect report generation management process

In the effect report providing system 100, the following AI control introduction effect report generation management process is performed. At a first step, the operator O inputs the effect report generation purpose data to the server device 10 via the operator terminal 20. At a second step, the server device 10 generates the AI control introduction effect report. At a third step, the server device 10 notifies the operator O of the AI control introduction effect report.

1-3-4. Effects of effect report providing system 100

The following effects are provided in the effect report providing system 100. As a first effect, in the effect report providing system 100, the operator O is able to verify the introduction effect of the AI control model CM even if the operator O is a non-AI engineer who does not have knowledge of the simulation models SM and the AI control models CM used in the plant. As a second effect, in the effect report providing system 100, when the operator O simply inputs a process value of the plant, the simulation models SM and the AI control models CM are automatically generated, and also, the AI control introduction effect report is automatically generated. Consequently, it is possible to verify the introduction effect of AI control on the basis of the content in the AI control introduction effect report. As a third effect, in the effect report providing system 100, the server device 10 is able to output, as the AI control introduction effect report, a graph indicating statistical values (average value, standard deviation, etc.), an offset (deviation), rise time, or the like of the output result of the AI control, or a graph in which an output result of the AI control is able to be compared with a case where the AI control is not performed.

As described above, in the effect report providing system 100, it is possible to easily verify the effects of the AI control that is introduced to the system.

2. Configuration and process related to each device included in effect report providing system 100

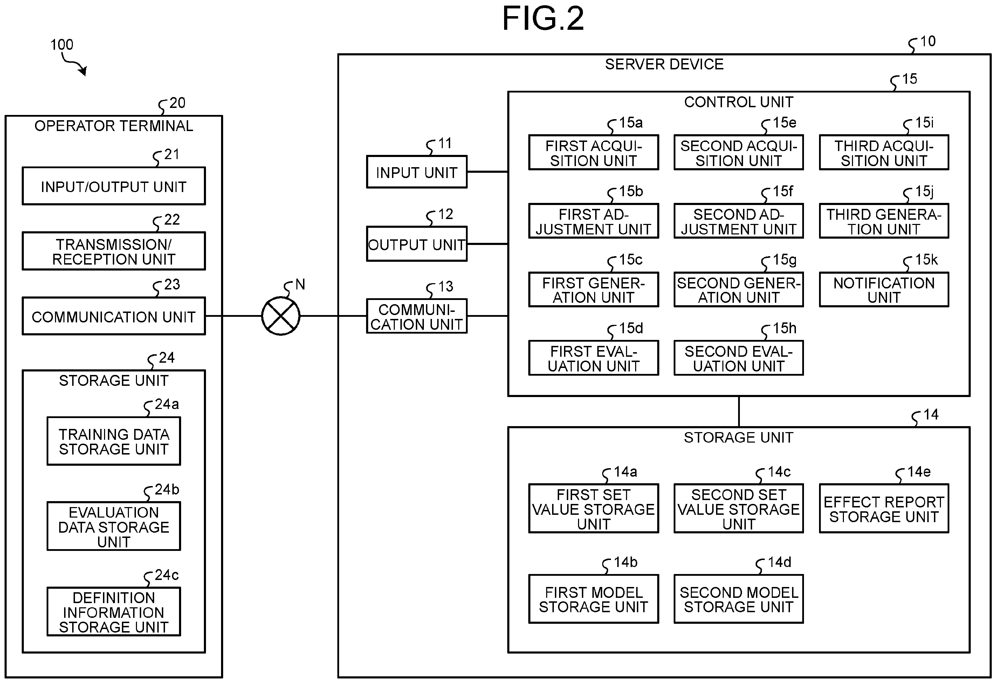

A configuration and a process related to each of the devices included in the effect report providing system 100 illustrated in FIG. 1 will be described with reference to FIG. 2 to FIG. 13. In the following, an example of the overall configuration and an example of the overall process of the effect report providing system 100 will be described first, and then, a configuration example and a process example of the server device 10, and a configuration example and a process example of the operator terminal 20 will be described in detail.

2-1. Example of overall configuration of effect report providing system 100

An example of the overall configuration of the effect report providing system 100 illustrated in FIG. 1 will be described with reference to FIG. 2. FIG. 2 is a block diagram illustrating a configuration example of each of the devices included in the effect report providing system 100 according to the embodiment. As illustrated in FIG. 2, the effect report providing system 100 includes the server device 10 and the operator terminal 20. Furthermore, the server device 10 and the operator terminal 20 are connected to one another via a communication network implemented by the Internet, a dedicated line, or the like so as to be able to communicate each other in a wired or wireless manner.

The server device 10 is installed in a cloud environment, an on-premise environment, an edge environment, or the like. Furthermore, the operator terminal 20 is installed in a monitoring room or the like that is provided in the plant and that is managed by the operator O.

2-2. Example of overall process performed in effect report providing system 100

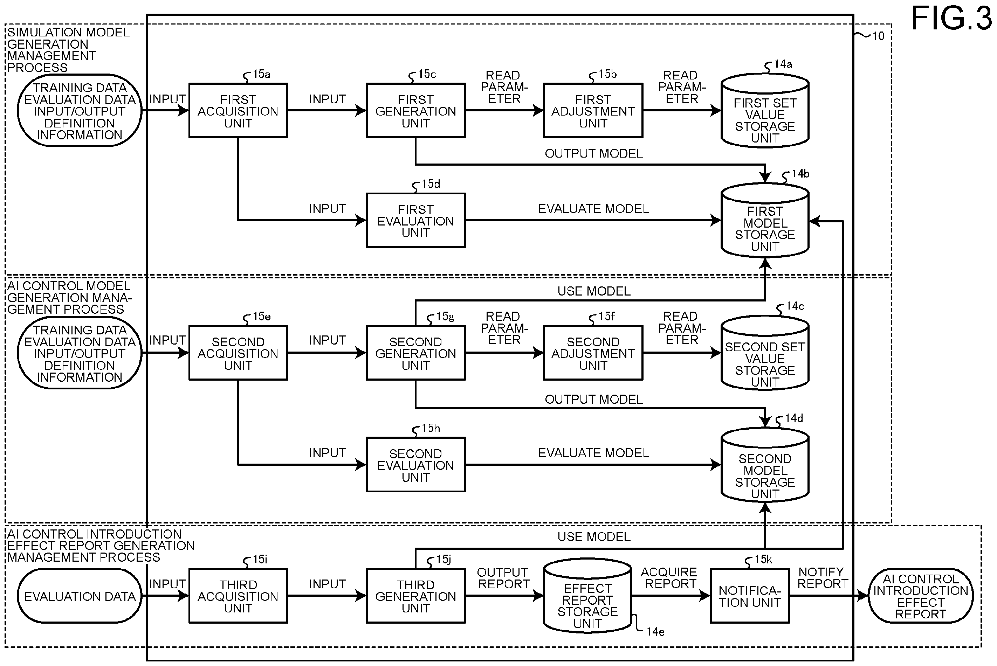

An example of the overall process performed in the effect report providing system 100 illustrated in FIG. 1 will be described with reference to FIG. 3. FIG. 3 is a block diagram illustrating an example of the overall process performed in the effect report providing system 100 according to the embodiment. The simulation model generation management process, the AI control model generation management process, and the AI control introduction effect report generation management process that are performed by the effect report providing system 100 will be described.

2-2-1. Simulation model generation management process

At a first step, a process example of the simulation model generation management process performed by the effect report providing system 100 will be described. In the simulation model generation management process, each of a first set value storage unit 14a and a first model storage unit 14b that will be described later and that are included in the storage unit 14 in the server device 10 and each of a first acquisition unit 15a, a first adjustment unit 15b, a first generation unit 15c, a first evaluation unit 15d that will be described later and that are included in a control unit 15 in the server device 10, and the like perform the process.

2-2-1-1. Simulation model generation purpose data input process

In the simulation model generation purpose data input process, the operator terminal 20 inputs training data, evaluation data, and simulation model input/output definition information that are simulation model generation purpose data to the first acquisition unit 15a included in the server device 10. Furthermore, the first acquisition unit 15a inputs the received training data, the evaluation data, and the simulation model input/output definition information to the first generation unit 15c. Furthermore, the first acquisition unit 15a inputs the received evaluation data to the first evaluation unit 15d.

2-2-1-2. Simulation model generation purpose set parameter creation process

In the simulation model generation purpose set parameter creation process, the first adjustment unit 15b reads out the simulation model generation purpose set parameters before adjustment by referring to the first set value storage unit 14a, and generates N patterns of the simulation model generation purpose set parameters on the basis of the grid search. Furthermore, the first adjustment unit 15b stores the generated N patterns of the simulation model generation purpose set parameters in the first set value storage unit 14a.

Specific example of simulation model generation purpose set parameters

Here, a specific example of the simulation model generation purpose set parameters generated by the first adjustment unit 15b will be described. For example, two types of simulation model generation purpose set parameters A and B before adjustment are present, and, in a case where candidate values for the set parameter A are "0.1, 0.01, 0.001" and candidate values for the set parameter B are " 1, 0.1, 0.01", the first adjustment unit 15b combines the candidate values for each of the set parameters, and generates nine patterns of simulation model generation purpose set parameters of (A: 0.1, B: 1), (A: 0.1, B: 0.1), (A: 0.1, B: 0.01), (A: 0.01, B: 1), (A: 0.01, B: 0.1), (A: 0.01, B: 0.01), (A: 0.001, B: 1), (A: 0.001, B: 0.1), and (A: 0.001, B: 0.01).

2-2-1-3. Simulation model generation process

In the simulation model generation process, the first generation unit 15c reads out the adjusted simulation model generation purpose set parameters by referring to the first set value storage unit 14a via the first adjustment unit 15b. Furthermore, the first generation unit 15c generates the N simulation models SM by inputting the training data to the simulation models SM, inputting the N patterns of the simulation model generation purpose set parameters to the simulation models SM, and inputting the simulation model generation purpose input/output definition information to the simulation models SM. Furthermore, the first generation unit 15c stores the generated N simulation models SM in the first model storage unit 14b.

2-2-1-4. Simulation model evaluation process

In the simulation model evaluation process, the first evaluation unit 15d refers to the N simulation models SM that are stored in the first model storage unit 14b, inputs the evaluation data to each of the N simulation models SM, calculates each of the simulation model evaluation values, and determines the simulation model SM having the maximum simulation model evaluation value from among the N simulation models SM as the best simulation model SM (Best) indicating the best performance. Furthermore, the first evaluation unit 15d stores only the best simulation model SM (Best) in the first model storage unit 14b, and deletes the other simulation models SM from the first model storage unit 14b.

2-2-2. AI control model generation management process

At a second step, a process example of the AI control model generation management process performed by the effect report providing system 100 will be described. In the AI control model generation management process, a second set value storage unit 14c and a second model storage unit 14d that will be described later and that are included in the storage unit 14 in the server device 10, and a second acquisition unit 15e, a second adjustment unit 15f, a second generation unit 15g, a second evaluation unit 15h that will be described later and that are included in the control unit 15, and the like perform the process.

2-2-2-1. AI control model generation purpose data input process

In the AI control model generation purpose data input process, the operator terminal 20 inputs the training data, the evaluation data, and the AI control model input/output definition information that are the AI control model generation purpose data to the second acquisition unit 15e included in the server device 10. Furthermore, the second acquisition unit 15e inputs the received training data, the evaluation data, and the AI control model input/output definition information to the second generation unit 15g. Furthermore, the second acquisition unit 15e inputs the received evaluation data to the second evaluation unit 15h.

2-2-2-2. AI control model generation purpose set parameter creation process

In the AI control model generation purpose set parameter creation process, the second adjustment unit 15f reads out the AI control model generation purpose set parameters before adjustment by referring to the second set value storage unit 14c, and generates M patterns of the AI control model generation purpose set parameters on the basis of the grid search. Furthermore, the second adjustment unit 15f stores the generated M patterns of the AI control model generation purpose set parameters in the second set value storage unit 14c.

2-2-2-3. AI control model generation process

In the AI control model generation process, the second generation unit 15g reads out the adjusted AI control model generation purpose set parameters by referring to the second set value storage unit 14c via the second adjustment unit 15f. Furthermore, the second generation unit 15g generates the M AI control models CM by inputting the training data to the AI control models CM, inputting the M patterns of the AI control model generation purpose set parameters to the AI control model CM, and inputting the AI control model generation purpose input/output definition information to the AI control model CM. At this time, the second generation unit 15g generates the AI control model CM by using the best simulation model SM (Best) that is stored in the first model storage unit 14b. Furthermore, the second generation unit 15g stores the generated M AI control models CM in the second model storage unit 14d.

2-2-2-4. AI control model evaluation process

In the AI control model evaluation process, the second evaluation unit 15h refers to the M AI control models CM stored in the second model storage unit 14d, inputs the evaluation data to each of the M AI control models CM, calculates each of the AI control model evaluation values, and determines the AI control model CM having the maximum AI control model evaluation value from among the M AI control models CM as the best AI control model CM (Best) indicating the best performance. Furthermore, the first evaluation unit 15d stores only the best AI control model CM (Best) in the second model storage unit 14d, and deletes the other AI control models CM from the second model storage unit 14d.

2-2-3. AI control introduction effect report generation management process

At a third step, a process example of the AI control introduction effect report generation management process performed by the effect report providing system 100 will be described. In the AI control introduction effect report generation management process, an effect report storage unit 14e that will be described later and that is included in the storage unit 14 in the server device 10, a third acquisition unit 15i, a third generation unit 15j, and a notification unit 15k that will be described later and that is included in the control unit 15 in the server device 10, and the like perform the process.

2-2-3-1. AI control introduction effect report generation purpose data input process

In the AI control introduction effect report generation purpose data input process, the operator terminal 20 inputs the evaluation data corresponding to the AI control introduction effect report generation purpose data to the third acquisition unit 15i included in the server device 10. Furthermore, the third acquisition unit 15i inputs the received evaluation data to the third generation unit 15j.

1-2-3-2. AI control introduction effect report generation process

In the AI control introduction effect report generation process, the third generation unit 15j generates the AI control introduction effect report by using the best simulation model SM (Best) stored in the first model storage unit 14b and using the best AI control model CM (Best) stored in the second model storage unit 14d. At this time, the third generation unit 15j inputs the evaluation data to the best simulation model SM (Best), and generates prediction data indicated in a case where the AI control is not performed. Furthermore, the third generation unit 15j inputs the control data that has been output by inputting the evaluation data to the best AI control model CM (Best) to the best simulation model SM (Best), and generates prediction data indicated in a case where the AI control is performed. Furthermore, the third generation unit 15j generates the AI control introduction effect report including a bar graph in which statistical values (average value and standard deviation) of the respective pieces of prediction data are able to be compared, a time series graph in which time series variations in the respective pieces of prediction data are able to be compared, and the like. Furthermore, the third generation unit 15j stores the generated AI control introduction effect report in the effect report storage unit 14e.

1-2-3-3. AI control introduction effect report notification process

In the AI control introduction effect report notification process, the notification unit 15k acquires the AI control introduction effect report stored in the effect report storage unit 14e, and transmits the AI control introduction effect report to the operator terminal 20. At this time, the notification unit 15k causes the monitor of the operator terminal 20 to display the AI control introduction effect report.

2-3. Configuration example and process example of server device 10

A configuration example and a process example of the server device 10 will be described with reference again to FIG. 2. The server device 10 is an information providing apparatus, and includes an input unit 11, an output unit 12, a communication unit 13, storage unit 14, and the control unit 15.

2-3-1. Input unit 11

The input unit 11 manages an input of various kinds of information to the server device 10. For example, the input unit 11 is implemented by a mouse, a keyboard, or the like, receives an input of various kinds of information with respect to the server device 10.

2-3-2. Output unit 12

The output unit 12 manages an output of various kinds of information received from the server device 10. For example, the output unit 12 is implemented by a display, or the like, and displays various kinds of information stored in the server device 10.

2-3-3. Communication unit 13

The communication unit 13 manages data communication performed with the other devices. For example, the communication unit 13 performs data communication with each of the communication devices via a router, or the like. Furthermore, the communication unit 13 is able to perform data communication with a terminal that is used by an operator (not illustrated).

2-3-4. Storage unit 14

The storage unit 14 stores therein various kinds of information referred to by the control unit 15 when the control unit 15 operates, and various kinds of information that have been acquired when the control unit 15 operates. The storage unit 14 includes the first set value storage unit 14a, the first model storage unit 14b, the second set value storage unit 14c, the second model storage unit 14d, and the effect report storage unit 14e. Here, the storage unit 14 is implemented by, for example, a semiconductor memory device, such as a random access memory (RAM) or a flash memory, or a storage device, such as a hard disk or an optical disk. Furthermore, in the example illustrated in FIG. 2, the storage unit 14 is installed in the server device 10; however, the storage unit 14 may be installed outside the server device 10, or a plurality of storage units may be installed.

2-3-4-1. First set value storage unit 14a

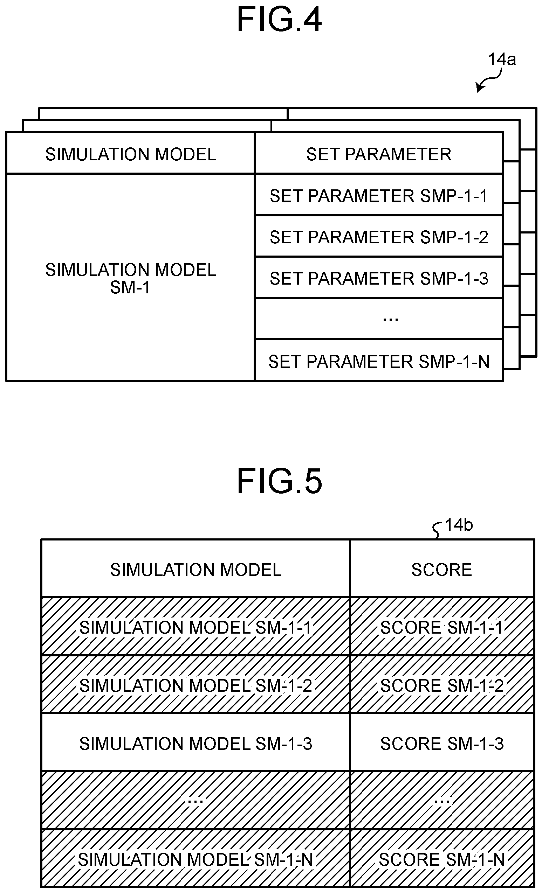

The first set value storage unit 14a stores therein the simulation model generation purpose set parameters. For example, the first set value storage unit 14a stores therein the simulation model generation purpose set parameters that are generated by the first adjustment unit 15b that will be described later and that is included in the control unit 15. In the following, one example of the data stored in the first set value storage unit 14a will be described with reference to FIG. 4. FIG. 4 is a diagram illustrating one example of the first set value storage unit 14a included in the server device 10 according to the embodiment. In the example illustrated in FIG. 4, the first set value storage unit 14a includes items of a "simulation model" and a "set parameter".

The "simulation model" indicates identification information for identifying the simulation models SM, and is, for example, an identification number or an identification symbol of each of the simulation models SM. The "set parameter" is a candidate for a hyperparameter to be input to the simulation model SM, and is, for example, a combination of each of the candidate values for the hyperparameters generated on the basis of the grid search.

In other words, FIG. 4 illustrates an example in which the first set value storage unit 14a stores therein, regarding the simulation model SM identified by a "simulation model SM-1", pieces of data related to the N patterns of the simulation model generation purpose set parameters identified by a "set parameter SMP-1-1", a "set parameter SMP-1-2", a "set parameter SMP-1-3", ... , a "set parameter SMP-1-N", and the like.

2-3-4-2. First model storage unit 14b

The first model storage unit 14b stores therein the simulation models SM. For example, the first model storage unit 14b stores therein the simulation models SM that are the machine learning models generated by the first generation unit 15c that will be described later and that is included in the control unit 15. Furthermore, the first model storage unit 14b stores therein the simulation model evaluation values calculated by the first evaluation unit 15d that will be described later and that is included in the control unit 15. In the following, one example of the data stored in the first model storage unit 14b will be described with reference to FIG. 5. FIG. 5 is a diagram illustrating one example of the first model storage unit 14b included in the server device 10 according to the embodiment. In the example illustrated in FIG. 5, the first model storage unit 14b includes items of a "simulation model" and a "score".

The "simulation model" is model data of each of the trained simulation models SM, and is data including, for example, execution data, hyperparameters, or the like for executing an algorithm of the simulation model SM. The "score" is an evaluation value that indicates the performance of each of the trained simulation models SM, and is a match rate between, for example, a sensor value that has been collected in the plant and a sensor value that has been output as the prediction data.

In other words, FIG. 5 illustrates an example in which the N trained simulation models SM and simulation model evaluation values that are indicated by {simulation model: "simulation model SM-1-1", score: "score SM-1-1"}, {simulation model: "simulation model SM-1-2", score: "score SM-1-2"}, {simulation model: "simulation model SM-1-3", score: "score SM-1-3"}, ... , and {simulation model: "simulation model SM-1-N", score: "score SM-1-N"} are temporarily stored in the first model storage unit 14b, and the pieces of data other than {simulation model: "simulation model SM-1-3", score: "score SM-1-3"} have been deleted.

2-3-4-3. Second set value storage unit 14c

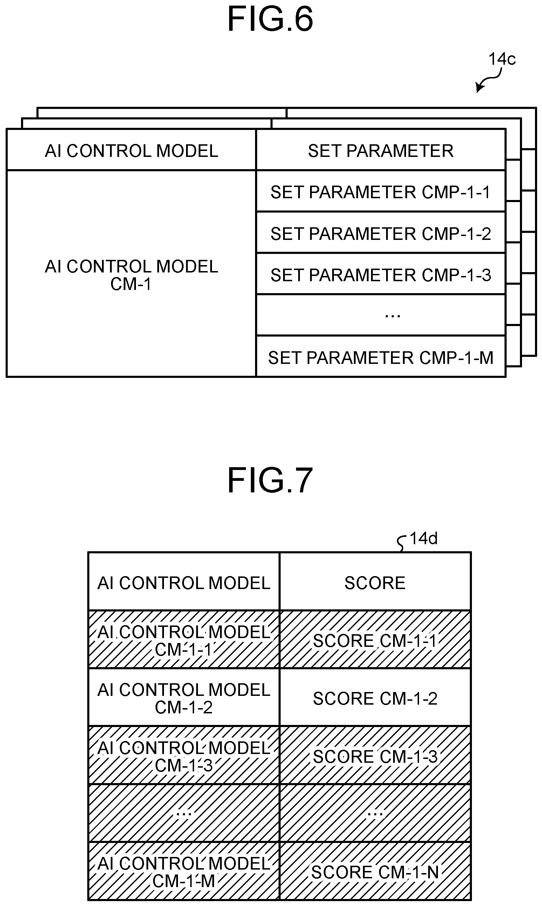

The second set value storage unit 14c stores therein the AI control model generation purpose set parameters. For example, the second set value storage unit 14c stores therein the AI control model generation purpose set parameters generated by the second adjustment unit 15f that will be described later and that is included in the control unit 15. In the following, one example of the data stored in the second set value storage unit 14c will be described with reference to FIG. 6. FIG. 6 is a diagram illustrating one example of the second set value storage unit 14c included in the server device 10 according to the embodiment. In the example illustrated in FIG. 6, the first set value storage unit 14a includes items of a "control model" and a "set parameter".

The "AI control model" indicates identification information for identifying the AI control model CM, and is, for example, an identification number or an identification symbol of the AI control model CM. The "set parameter" is a candidate for a hyperparameter to be input to the AI control model CM, and is, for example, a combination of candidate values for the respective hyperparameters generated on the basis of the grid search.

In other words, FIG. 6 illustrates an example in which the second set value storage unit 14c stores therein, regarding the AI control model CM identified by an "AI control model CM-1", pieces of data related to the M patterns of the AI control model generation purpose set parameters identified by a "set parameter CMP-1-1", a "set parameter CMP-1-2", a "set parameter CMP-1-3", ... , and a "set parameter CMP-1-M", and the like.

2-3-4-4. Second model storage unit 14d

The second model storage unit 14d stores therein the AI control models CM. For example, the second model storage unit 14d stores therein AI control model CM that are machine learning models generated by the second generation unit 15g that will be described later and that is included in the control unit 15. In the following, one example of the data stored by the second model storage unit 14d will be described with reference to FIG. 7. FIG. 7 is a diagram illustrating one example of the second model storage unit 14d included in the server device 10 according to the embodiment. In the example illustrated in FIG. 7, the second model storage unit 14d includes items of an "AI control model" and a "score".

The "AI control model" is model data of a trained AI control model CM, and is, for example, execution data for executing the algorithm of the AI control model CM, or data including hyperparameters, or the like. The "score" is an evaluation value that indicates the performance of each of the trained AI control models CM, and is, for example, a reward value that is calculated by using a reward function and that is indicated when the process performed in the plant is controlled.

In other words, FIG. 7 illustrates an example in which the M trained AI control models CM and AI control model evaluation values that are indicated by {AI control model: "AI control model CM-1-1", score: "score CM-1-1"}, {AI control model: "AI control model CM-1-2", score: "score CM-1-2"}, {AI control model: "AI control model CM-1-3", score: "score CM-1-3"}, ... , and {AI control model: "AI control model CM-1-M", score: "score CM-1-M"} are temporarily stored in the first model storage unit 14b, and the pieces of data other than {AI control model: "AI control model CM-1-2", score: "score CM-1-2"} have been deleted.

2-3-4-5. Effect report storage unit 14e

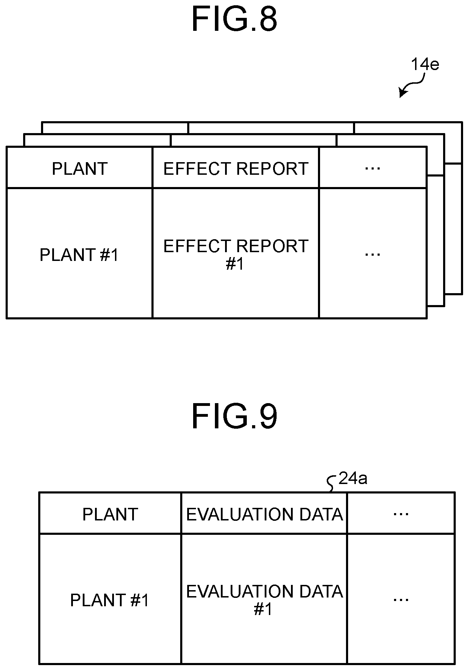

The effect report storage unit 14e stores therein the AI control introduction effect report. For example, the effect report storage unit 14e stores therein the AI control introduction effect report generated by the third generation unit 15j that will be described later and that is included in the control unit 15. In the following, one example of the data stored in the effect report storage unit 14e will be described with reference to FIG. 8. FIG. 8 is a diagram illustrating one example of the effect report storage unit 14e included in the server device 10 according to the embodiment. In the example illustrated in FIG. 8, the effect report storage unit 14e includes items of a "plant", an "effect report", and the like.

The "plant" indicates identification information for identifying the plant that is a system, and is, for example, an identification number or an identification symbol of the plant. The "effect report" is a report that indicates the effect obtained in a case where the AI control model CM is introduced to the system, and is, for example, a report visualized by a graph in which a sensor value indicated in a case where the AI control model CM is not introduced to the plant is able to be compared with a sensor value indicated in a case where the AI control model CM is introduced.

In other words, FIG. 8 illustrates an example in which the effect report storage unit 14e stores therein, regarding the plant identified by a "plant #1", the data of the AI control introduction effect report identified by an "effect report #1".

2-3-5. Control unit 15

The control unit 15 manages the overall control of the server device 10. The control unit 15 includes the first acquisition unit 15a, the first adjustment unit 15b, the first generation unit 15c, the first evaluation unit 15d, the second acquisition unit 15e, the second adjustment unit 15f, the second generation unit 15g, the second evaluation unit 15h, the third acquisition unit 15i, the third generation unit 15j, and the notification unit 15k. Here, the control unit 15 is implemented by, for example, an electronic circuit, such as a central processing unit (CPU) or a micro processing unit (MPU), or an integrated circuit, such as an application specific integrated circuit (ASIC) or a field programmable gate array (FPGA).

2-3-5-1. First acquisition unit 15a

The first acquisition unit 15a acquires various kinds of information. Furthermore, the first acquisition unit 15a may store the acquired various kinds of information in the storage unit 14.

The first acquisition unit 15a acquires the pieces of operational data collected from the system. For example, the first acquisition unit 15a acquires, as the operational data transmitted by the operator terminal 20, training data including a data set of a sensor value that indicates a state of a process performed in the plant and an operation value that indicates an operation performed on the process, evaluation data, or the like. Furthermore, the first acquisition unit 15a acquires the first definition information that defines an input/output signal to or from the simulation model SM, that is, simulation model generation purpose input/output definition information. For example, the first acquisition unit 15a acquires, as the simulation model generation purpose input/output definition information transmitted by the operator terminal 20, an input tag that is a name or an identifier of a process value that changes a state of a process, an output tag that is a name or an identifier of a process value that indicates the state of the process, a delay time between an input and an output indicating a period of time until the output data is changed in a case where the input data has been changed, or the like.

A specific example will be described. The first acquisition unit 15a acquires, as the simulation model generation purpose data transmitted by the operator terminal 20, data indicated by {plant: "plant #1", training data: "training data #1"}, {plant: "plant #1", evaluation data: "evaluation data #1"}, {plant: "plant #1", definition information 1: "definition information #1-1"}, and the like, and outputs the acquired data to the first generation unit 15c.

2-3-5-2. First adjustment unit 15b

The first adjustment unit 15b adjusts various kinds of information. Furthermore, the first adjustment unit 15b may store the adjusted various kinds of information in the storage unit 14. Furthermore, the first adjustment unit 15b may refer to the various kinds of information stored in the storage unit 14.

The first adjustment unit 15b generates a plurality of first set values, that is, a plurality of simulation model generation purpose set parameters. For example, the first adjustment unit 15b refers to the candidate values for the hyperparameters for the simulation models SM before adjustment, and generates a combination of the plurality of candidate values for the hyperparameters on the basis of the grid search.

A specific example will be described. The first adjustment unit 15b generates N patterns of the simulation model generation purpose set parameters of a "set parameter SMP-1-1", a "set parameter SMP-1-2", a "set parameter SMP-1-3", ... , and a "set parameter SMP-1-N" related to the simulation model SM identified by the "simulation model SM-1", and stores the generated parameters in the first set value storage unit 14a.

2-3-5-3. First generation unit 15c

The first generation unit 15c generates various kinds of information. Furthermore, the first generation unit 15c may store the generated various kinds of information in the storage unit 14. Furthermore, the first generation unit 15c may refer to the various kinds of information stored in the storage unit 14.

The first generation unit 15c generates, on the basis of the pieces of operational data collected from the system, a plurality of first models each of which outputs the prediction data on the operational status of the system in accordance with an input of the operational data, that is, the plurality of simulation models SM. For example, the first generation unit 15c generates a plurality of simulation models SM by using, for the training data, a data set of the sensor value that indicates the state of the process performed in the system and the operation value that indicates the operation performed on the process as the operational data; using, as the plurality of simulation model generation purpose set parameters, the plurality of hyperparameters generated on the basis of the grid search; and further using the simulation model generation purpose input/output definition information that defines an input/output signal to or from the simulation model SM.

A specific example will be described. The first generation unit 15c inputs, to the simulation model SM identified by the "simulation model SM-1", each of {plant: "plant #1", training data: "training data #1"} as the data set of the training data output by the first acquisition unit 15a, {plant: "plant #1", definition information 1: "definition information #1-1"} as the simulation model generation purpose input/output definition information output by the first acquisition unit 15a, and the parameters of the "set parameter SMP-1-1 ", the "set parameter SMP-1-2", the "set parameter SMP-1-3", ... , and the "set parameter SMP-1-N" as the N patterns of the simulation model generation purpose set parameters stored in the first set value storage unit 14a; generates, as the N simulation models SM, the "simulation model SM-1-1", the "simulation model SM-1-2", the "simulation model SM-1-3", ... , and the "simulation model SM-1-N"; and stores the generated N simulation models SM in the first model storage unit 14b.

2-3-5-4. First evaluation unit 15d

The first evaluation unit 15d evaluates various kinds of information. Furthermore, the first evaluation unit 15d may store the evaluation result in the storage unit 14. Furthermore, the first evaluation unit 15d may refer to the various kinds of information stored in the storage unit 14.

The first evaluation unit 15d determines, on the basis of the operational data, the first evaluation value for evaluating the plurality of generated simulation models SM, that is, the simulation model SM having the maximum simulation model evaluation value. For example, the first evaluation unit 15d uses, for the evaluation data, the data set of the sensor value that indicates the state of the process performed in the system and the operation value that indicates the operation performed on the process as the operational data, calculates, as the simulation model evaluation value, a match rate between the sensor value collected from the system and the sensor value output as the prediction data, and determines the simulation model SM in which the calculated match rate is the highest from among the plurality of generated simulation models SM.

At this time, the first evaluation unit 15d calculates, as indicated by Equation (1) below, the match rate between the operational data that is the process value indicated at the time of actual control and the process value simulated by the simulation model SM as a simulation model evaluation value $S_{SM}$.

$$S_{SM} = 100 \left( 1 - \frac{||y - \hat{y}||}{||y - mean(y)||} \right) \qquad \cdots (1)$$

y: process value at time of actual control,

ẙ: simulated process value

A specific example will be described. The first evaluation unit 15d inputs {plant: "plant #1", evaluation data: "evaluation data #1"} as the data set of the evaluation data output by the first acquisition unit 15a to each of the "simulation model SM-1-1", the "simulation model SM-1-2", the "simulation model SM-1-3", ... , and the "simulation model SM-1-N" as the N simulation model SM; calculates each of the "score SM-1-1", the "score SM-1-2", the "score SM-1-3 ", ... , and the "score SM-1-N" as the N simulation model evaluation values; and stores the calculated values in the first model storage unit 14b. Furthermore, the first evaluation unit 15d identifies the "score SM-1-3" as the maximum simulation model evaluation value and the "simulation model SM-1-3" as the corresponding best simulation model SM (Best); and deletes the pieces of data stored in the first model storage unit 14b except for the data of {simulation model: "simulation model SM-1-3", score: "score SM-1-3"}.

2-3-5-5. Second acquisition unit 15e

The second acquisition unit 15e acquires various kinds of information. Furthermore, the second acquisition unit 15e may store the acquired various kinds of information in the storage unit 14.

The second acquisition unit 15e acquires the pieces of operational data collected from the system. For example, the second acquisition unit 15e acquires the training data, the evaluation data, and the like including the data set of the sensor value that indicates the state of the process performed in the plant and the operation value that indicates the operation performed on the process as the operational data transmitted by the operator terminal 20. Furthermore, the second acquisition unit 15e acquires the second definition information that defines an input/output signal to or from the AI control model CM, that is, the AI control model generation purpose input/output definition information. For example, the second acquisition unit 15e acquires, as the AI control model generation purpose input/output definition information transmitted by the operator terminal 20, an observation tag that is a name or an identifier of the process value observed at the time of operation performed by the AI control model CM, a control tag that is a name or an identifier of the process value operated by the AI control model CM, an operation cycle at the time of the operation, or the like.

A specific example will be described. The second acquisition unit 15e acquires {plant: "plant #1", training data: "training data #1"}, {plant: "plant #1", evaluation data: "evaluation data #1"}, {plant: "plant #1", definition information 2:"definition information #1-2"}, and the like as the AI control model generation purpose data transmitted by the operator terminal 20, and outputs the acquired data in the second generation unit 15g.

2-3-5-6. Second adjustment unit 15f

The second adjustment unit 15f adjusts various kinds of information. Furthermore, the second adjustment unit 15f may store the adjusted various kinds of information in the storage unit 14. Furthermore, the second adjustment unit 15f may refer to the various kinds of information stored in the storage unit 14.

The second adjustment unit 15f generates the plurality of second set values, that is, the plurality of AI control model generation purpose set parameters. For example, the second adjustment unit 15f refers to the candidate values for the hyperparameters for the AI control model CM before adjustment, and generates a combination of the candidate values for the plurality of hyperparameters on the basis of the grid search.

A specific example will be described. The second adjustment unit 15f generates, regarding the AI control model CM identified by the "AI control model CM-1", the M patterns of the AI control model generation purpose set parameters of the "set parameter CMP-1-1", the "set parameter CMP-1-2", the "set parameter CMP-1-3", ... , and the "set parameter CMP-1-M", and then, stores the generated parameters in the second set value storage unit 14c.

2-3-5-7. Second generation unit 15g

The second generation unit 15g generates various kinds of information. Furthermore, the second generation unit 15g may store the generated various kinds of information in the storage unit 14. Furthermore, the second generation unit 15g may refer to the various kinds of information stored in the storage unit 14.

The second generation unit 15g generates, on the basis of the pieces of operational data collected from the system and the determined simulation model SM, the plurality of second models each of which outputs the control data related to control of the system in accordance with an input of the operational data, that is, the plurality of AI control models CM. For example, the second generation unit 15g generates the plurality of AI control models CM by using, for the training data, the data set of the sensor value that indicates the state of the process performed in the system and the operation value that indicates the operation performed on the process as the operational data; using the plurality of hyperparameters generated on the basis of the grid search as the plurality of AI control generation purpose set parameters; further using the AI control model generation purpose input/output definition information that defines an input/output signal to or from the AI control model CM; and using the determined simulation model SM.

A specific example will be described. The second generation unit 15g inputs each of {plant: "plant #1", training data: "training data #1"} as the data set of the training data output by the second acquisition unit 15e, {plant: "plant #1", definition information 2: "definition information #1-2"} as the AI control model generation purpose input/output definition information output by the second acquisition unit 15e, the "set parameter CMP-1-1", the "set parameter CMP-1-2", the "set parameter CMP-1-3", ... , and the "set parameter CMP-1-M" as the M patterns of the AI control model generation purpose set parameters stored in the second set value storage unit 14c to the AI control model CM identified by the "AI control model CM-1" in the execution environment of the "simulation model SM-1-3" that is the best simulation model SM (Best) stored in the first model storage unit 14b; generates the "AI control model CM-1-1", the "AI control model CM-1-2", the "AI control model CM-1-3", ... , and the "AI control model CM-1-M" as the M AI control models CM; and stores the generated M AI control models CM in the second model storage unit 14d.

2-3-5-8. Second evaluation unit 15h

The second evaluation unit 15h evaluates various kinds of information. Furthermore, the second evaluation unit 15h may store the evaluation result in the storage unit 14. In addition, the second evaluation unit 15h may refer to the various kinds of information stored in the storage unit 14.

The second evaluation unit 15h determines, on the basis of the operational data, the second evaluation value for evaluating the plurality of generated AI control models CM, that is, the AI control model CM having the maximum AI control model evaluation value. For example, the second evaluation unit 15h uses, for the evaluation data, the data set of the sensor value that indicates the state of the process performed in the system and the operation value that indicates the operation performed on the process as the operational data, calculates an average value of the reward values indicated when the system is controlled by using the reward function as the AI control model evaluation value, and determines the AI control model CM in which the calculated average value of the reward value is the maximum value from among the plurality of generated AI control models CM.

At this time, the second evaluation unit 15h uses a reward value R and an evaluation period n of the evaluation data, and calculates the average value of the reward value R as an AI control model evaluation value $S_{CM}$ by using Equation (2) below.

$$S_{CM} = \frac{1}{n} \sum_{i=0}^{n} R_i \qquad \cdots (2)$$

R: reward value, n: evaluation period of evaluation data

The reward value R mentioned here is a value calculated by using the reward function in order to evaluate how an agent used in reinforcement learning takes actions in an environment, and, for example, a difference value between a control target value of a control target and a current value of the control target at the time of control, or the like is used as a reward function, but the reward function to be used is not particularly limited.

A specific example will be described. The second evaluation unit 15h inputs {plant: "plant #1", evaluation data: "evaluation data #1"} as the data set of the evaluation data output by the second acquisition unit 15e to each of the "AI control model CM-1-1", the "AI control model CM-1-2", the "AI control model CM-1-3", ... , and the "AI control model CM-1-M" as the M AI control models CM; calculates each of the "score CM-1-1", the "score CM-1-2", "score CM-1-3", ... , and the "score CM-1-M" as the M AI control model evaluation values; and stores the calculated values in the second model storage unit 14d. Furthermore, the second evaluation unit 15h identifies the "score CM-1-2" as the maximum AI control model evaluation value and the "AI control model CM-1-2" as the corresponding best AI control model CM (Best), and deletes the data stored in the second model storage unit 14d except for the data of {AI control model: "AI control model CM-1-2", score: "score CM-1-2"}.

2-3-5-9. Third acquisition unit 15i

The third acquisition unit 15i acquires various kinds of information. Furthermore, the third acquisition unit 15i may store the acquired various kinds of information in the storage unit 14.

The third acquisition unit 15i acquires the pieces of operational data collected from the system. For example, the third acquisition unit 15i acquires the evaluation data including the data set of the sensor value that indicates the state of the process performed in the plant and the operation value that indicates the operation performed on the process, or the like as the operational data transmitted by the operator terminal 20.

A specific example will be described. The third acquisition unit 15i acquires {plant: "plant #1", evaluation data: "evaluation data #1"}, or the like as the AI control introduction effect report generation purpose data transmitted by the operator terminal 20, and outputs the acquired data to the third generation unit 15j.

2-3-5-10. Third generation unit 15j

The third generation unit 15j generates various kinds of information. Furthermore, the third generation unit 15j may store the generated various kinds of information in the storage unit 14. Furthermore, the third generation unit 15j may refer to the various kinds of information stored in the storage unit 14.

The third generation unit 15j generates the effect report that indicates the effect obtained in a case where the AI control model CM is introduced to the system, that is, the AI control introduction effect report, on the basis of the operational data, the determined simulation model SM, and the determined AI control model CM. For example, the third generation unit 15j generates the AI control introduction effect report that displays the graph in which the average value and the standard deviation of the sensor values each of which indicates the state of the process output by inputting the operation value that indicates the operation performed on the process in the system as the operational data to the determined simulation model SM is able to be compared with the average value and the standard deviation of the sensor values each of which has been output by inputting the control data output by the AI control model CM to the determined simulation model SM. Furthermore, the third generation unit 15j generates the AI control introduction effect report that displays the graph in which the time series variation in the sensor values each of which indicates the state of the process that has been output by inputting the operation value that indicates the operation performed on the process in the system as the operational data to the determined simulation model SM is able to be compared with the time series variation in the sensor values output by inputting the control data output by the AI control model CM to the determined simulation model SM.

A specific example will be described. The third generation unit 15j inputs {plant: "plant #1", evaluation data: "evaluation data #1"} as the data set of the evaluation data output from the third acquisition unit 15i to the "simulation model SM-1-3" that is the best simulation model SM (Best) stored in the first model storage unit 14b, and generates the prediction data "sensor value SM-1-3" indicated in a case where the AI control is not performed. Furthermore, the third generation unit 15j further inputs the control data "control data CM-1-2", which has been output by inputting {plant: "plant #1", evaluation data: "evaluation data #1"} as the data set of the evaluation data output by the third acquisition unit 15i to the "AI control model CM-1-2" that is the best AI control model CM (Best) stored in the second model storage unit 14d, to the "simulation model SM-1-3" that is the best simulation model SM (Best) stored in the first model storage unit 14b, and then, generates prediction data "sensor value SM-1-3 / CM-1-2" indicated in a case where the AI control is performed. Furthermore, the third generation unit 15j generates the "effect report #1" as the AI control introduction effect report that displays a bar graph, a time series graph, or the like in which the prediction data "sensor value SM-1-3" indicated in a case where the AI control is not performed is able to be compared with the prediction data "sensor value SM-1-3 / CM-1-2" indicated in a case where the AI control is performed, and stores the generated report in the effect report storage unit 14e.

2-3-5-11. Notification unit 15k

The notification unit 15k notifies various kinds of information. Furthermore, the notification unit 15k may refer to the various kinds of information stored in the storage unit 14.

The notification unit 15k notifies the AI control introduction effect report. For example, the notification unit 15k notifies the operator O of the AI control introduction effect report generated by the third generation unit 15j.

A specific example will be described. The notification unit 15k acquires the "effect report #1" as the AI control introduction effect report that is to be notified to the operator O from the effect report storage unit 14e, identifies the operator terminal 20 as the transmission destination of the AI control introduction effect report, transmits the "effect report #1" to the operator terminal 20, and causes the bar graph, the time series graph, or the like included in the "effect report #1" to be displayed on the display of the operator terminal 20.

2-4. Configuration example and process example of operator terminal 20

A configuration example and a process example of the operator terminal 20 will be described with reference again to FIG. 2. The operator terminal 20 is a posting device and a viewing device, and includes an input/output unit 21, a transmission/reception unit 22, a communication unit 23, and a storage unit 24.

2-4-1. Input/output unit 21

The input/output unit 21 manages an input of various kinds of information to the operator terminal 20. For example, the input/output unit 21 is implemented by a mouse, a keyboard, a touch panel, or the like, and receives an input of various kinds of information to the operator terminal 20. Furthermore, the input/output unit 21 manages display of various kinds of information received from the operator terminal 20. For example, the input/output unit 21 is implemented by a display, or the like, and displays various kinds of information stored in the operator terminal 20.

Furthermore, the input/output unit 21 displays the AI control introduction effect report transmitted from the server device 10 that is an information providing apparatus. Furthermore, the display screen of the AI control introduction effect report will be described in detail later titled by (2-4-5. first specific example of display screen of operator terminal 20) and (2-4-6. second specific example of display screen of operator terminal 20).

2-4-2. Transmission/reception unit 22

The transmission/reception unit 22 transmits various kinds of information. For example, the transmission/reception unit 22 transmits, as the pieces of operational data collected from the system, the training data, the evaluation data, or the like including the data set of the sensor value that indicates the state of the process performed in the system and the operation value that indicates the operation performed on the process. Furthermore, the transmission/reception unit 22 transmits, as the definition information that defines an input/output signal, the simulation model generation purpose input/output definition information, the AI control model generation purpose input/output definition information, or the like to the server device 10.

The transmission/reception unit 22 receives various kinds of information. For example, the transmission/reception unit 22 receives the AI control introduction effect report transmitted from the server device 10. Furthermore, the transmission/reception unit 22 receives the definition information, or the like that defines the operational data and an input/output signal transmitted from a predetermined database.

2-4-3. Communication unit 23

The communication unit 23 manages data communication with the other devices. For example, the communication unit 23 performs data communication with each of the communication devices by way of a router or the like. Furthermore, the communication unit 23 is able to perform data communication with a terminal that is used by an operator (not illustrated).

2-4-4. Storage unit 24

The storage unit 24 includes a training data storage unit 24a, an evaluation data storage unit 24b, and a definition information storage unit 24c. Here, the storage unit 24 may be implemented by, for example, a semiconductor memory device, such as a random access memory (RAM) or a flash memory, or a storage device, such as a hard disk or an optical disk. Furthermore, in the example illustrated in FIG. 2, the storage unit 24 is installed in the operator terminal 20; however, the storage unit 24 may be installed outside the operator terminal 20, or a plurality of storage units may be installed.

2-4-4-1. Training data storage unit 24a

The training data storage unit 24a stores therein the training data. For example, the training data storage unit 24a stores therein the training data including the data set of the sensor value that indicates the state of the process performed in the plant and the operation value that indicates the operation performed on the process as the operational data received by the transmission/reception unit 22. In the following, one example of the data stored in the training data storage unit 24a will be described with reference to FIG. 9. FIG. 9 is a diagram illustrating one example of the training data storage unit 24a included in the operator terminal 20 according to the embodiment. In the example illustrated in FIG. 9, the training data storage unit 24a includes items of a "plant", a "training data", and the like.

The "plant" indicates identification information for identifying the plant corresponding to the system, and is, for example, an identification number or an identification symbol of the plant. The "training data" is a data set for training the simulation model SM or the AI control model CM, and is, for example, the data set of the sensor value and the operation value collected in the actual environment in the plant.

In other words, FIG. 9 illustrates an example in which the training data storage unit 24a stores therein, regarding the plant identified by the "plant #1", data indicating the data set of the training data is the "training data #1".

2-4-4-2. Evaluation data storage unit 24b

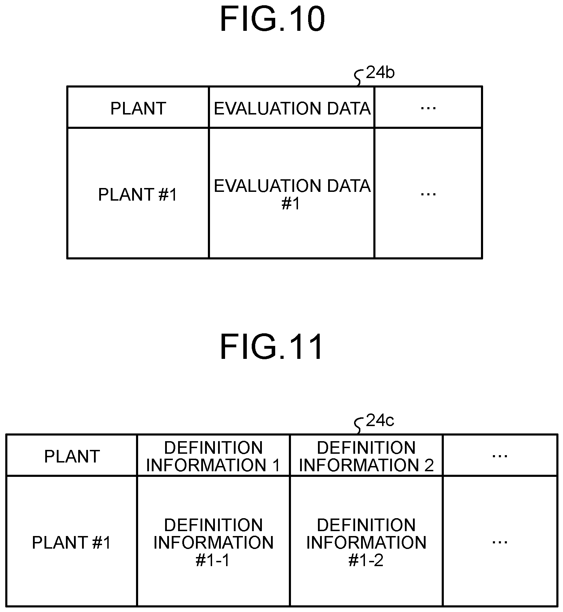

The evaluation data storage unit 24b stores therein the evaluation data. For example, the evaluation data storage unit 24b stores therein the evaluation data including the data set of the sensor value that indicates the state of the process performed in the plant and the operation value that indicates the operation performed on the process as the operational data received by the transmission/reception unit 22. In the following, one example of the data stored in the evaluation data storage unit 24b will be described with reference to FIG. 10. FIG. 10 is a diagram illustrating one example of the evaluation data storage unit 24b included in the operator terminal 20 according to the embodiment. In the example illustrated in FIG. 10, the evaluation data storage unit 24b includes items of the "plant", the "evaluation data", and the like.

The "plant" indicates identification information for identifying the plant corresponding to the system, and is, for example, an identification number or an identification symbol of the plant. The "evaluation data" is a data set that is used to evaluate the simulation model SM or the AI control model CM, and is, for example, the data set of the sensor value and the operation value that are different from the training data and that have been collected in the actual environment in the plant.

In other words, FIG. 10 illustrates an example in which the evaluation data storage unit 24b stores therein, regarding the plant identified by the "plant #1", the data indicating that the data set of the evaluation data is the "evaluation data #1".

2-4-4-3. Definition information storage unit 24c

The definition information storage unit 24c stores therein the definition information. For example, the definition information storage unit 24c stores therein the simulation model generation purpose input/output definition information, the AI control model generation purpose input/output definition information, and the like as the definition information received by the transmission/reception unit 22. In the following, one example of the data stored in the definition information storage unit 24c will be described with reference to FIG. 11. FIG. 11 is a diagram illustrating one example of the definition information storage unit 24c included in the operator terminal 20 according to the embodiment. In the example illustrated in FIG. 11, the definition information storage unit 24c includes items of a "plant", "definition information 1", "definition information 2", and the like.

The "plant" indicates identification information for identifying the plant corresponding to the system, and is, for example, an identification number or an identification symbol of the plant. The "definition information 1" is the simulation model generation purpose input/output definition information that defines an input/output signal to or from the simulation model SM, and is information on an input tag that is a name or an identifier of the process value that changes the state of the process, an output tag that is a name or an identifier of the process value that indicates the state of the process, a delay time between an input and an output indicating a period of time until the output data is changed in a case where the input data has been changed, or the like. The "definition information 2" is the AI control model generation purpose input/output definition information that defines an input/output signal to or from the AI control model CM, and is information on an observation tag that is a name or an identifier of the process value observed at the time of operation performed by the AI control model CM, a control tag that is a name or an identifier of the process value operated by the AI control model CM, an operation cycle at the time of control, or the like.

In other words, FIG. 11 illustrates an example in which the definition information storage unit 24c stores therein, regarding the plant identified by the "plant #1", data indicating that the simulation model generation purpose input/output definition information is the "definition information #1-1", the AI control model generation purpose input/output definition information is the "definition information #1-2", and the like.

2-4-5. First specific example of display screen of operator terminal 20

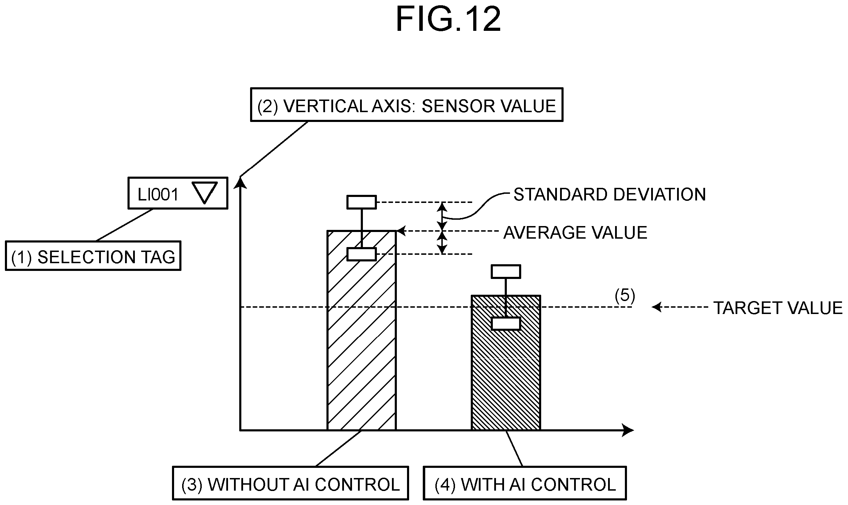

In the following, the AI control introduction effect report that indicates a bar graph of the sensor values will be described, with reference to FIG. 12, as a first specific example of the display screen that is output by the input/output unit 21 included in the operator terminal 20. FIG. 12 is a diagram illustrating the first specific example of the display screen of the operator terminal 20 according to the embodiment. In the following description, a "selection tag", a "vertical axis", "without AI control", "with AI control", and a "target value" will be described.

2-4-5-1. Selection tag

As indicated by (1) illustrated in FIG. 12, the operator terminal 20 displays the "selection tag" that displays a process performed in the system in a selectable manner. In the example indicated by (1) illustrated in FIG. 12, the operator terminal 20 displays "LI001" as the process that is performed in the plant and that has been selected by the operator O.

2-4-5-2. Vertical axis

As indicated by (2) illustrated in FIG. 12, the operator terminal 20 displays the graph having the "vertical axis" that indicates the value of the sensor value of the system selected by the operator O. In the example indicated by (2) illustrated in FIG. 12, the operator terminal 20 displays the sensor value of "LI001" indicating the process performed in the plant.

2-4-5-3. Without AI control

As indicated by (3) illustrated in FIG. 12, the operator terminal 20 displays the graph that indicates the average value and the standard deviation of the sensor values indicated in a case of "without AI control" that is a case in which the AI control model CM is not introduced to the system selected by the operator O. In the example indicated by (3) illustrated in FIG. 12, the operator terminal 20 displays a bar graph corresponding to the average value of the sensor values that is indicated in a case where the AI control is not performed on "LI001" that is the process performed in the plant, and displays an error bar corresponding to the standard deviation of the sensor values.

2-4-5-4. With AI control

As indicated by (4) illustrated in FIG. 12, the operator terminal 20 displays the graph that indicates the average value and the standard deviation of the process values related to a case of "with AI control" that is a case in which the AI control model CM is introduced to the system selected by the operator O. In the example indicated by (4) illustrated in FIG. 12, the operator terminal 20 displays the bar graph corresponding to the average value of the sensor values indicated in a case where the AI control is performed on "LI001" that is the process performed in the plant, and displays an error bar corresponding to the standard deviation of the sensor values.

2-4-5-5. Target value

As indicated by (5) illustrated in FIG. 12, the operator terminal 20 displays the graph having the "target value" that indicates the target value of the sensor value of the system selected by the operator O. In the example indicated by (5) illustrated in FIG. 12, the operator terminal 20 displays the target value of the sensor value of "LI001" that is the process performed in the plant by the broken lines, which is easy to visually understand that the sensor value indicated in a case where the AI control model CM is introduced to the system is closer to the target value as compared with the sensor value indicated in a case where the AI control model CM is not introduced to the system.

2-4-5-6. Others

The operator terminal 20 may display the bar graphs that indicate a plurality of types of sensor values side by side. Furthermore, the operator terminal 20 may display explanatory legends, in which a type and a name of a bar graph are associated with a shape and a color, and the bar graphs side by side.

2-4-6. Second specific example of display screen of operator terminal 20

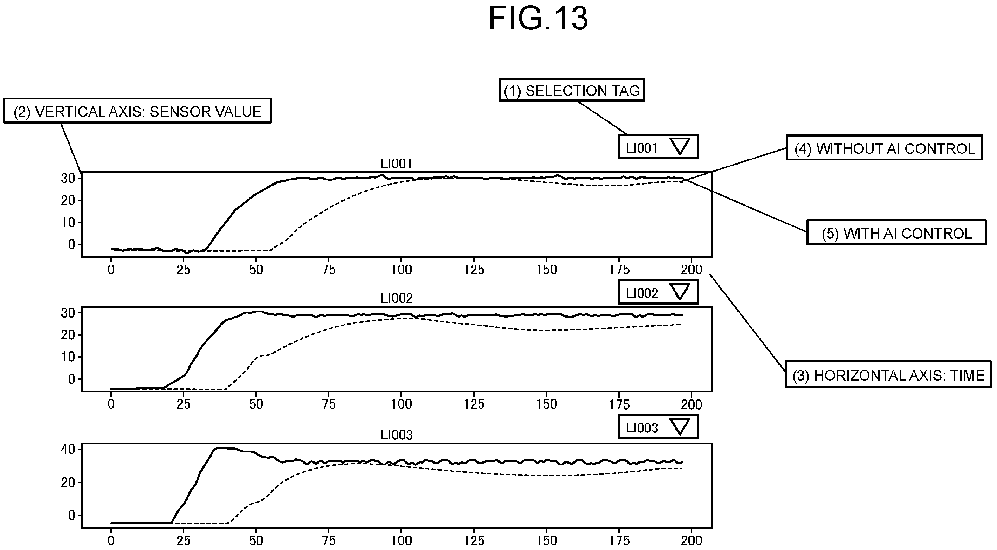

In the following, the AI control introduction effect report indicating a time series graph of the sensor values will be described, with reference to FIG. 13, as the second specific example of the display screen that is output by the input/output unit 21 included in the operator terminal 20. FIG. 13 is a diagram illustrating the second specific example of the display screen of the operator terminal 20 according to the embodiment. In the following description, a "selection tag", a "vertical axis", a "horizontal axis", "without AI control", and "with AI control" will be described.

2-4-6-1. Selection tag

As indicated by (1) illustrated in FIG. 13, the operator terminal 20 displays the "selection tag" that displays the process performed in the system in a selectable manner. In the example indicated by (1) illustrated in FIG. 13, the operator terminal 20 displays "LI001", "LI002", and "LI003" as the processes performed in the plant selected by the operator O.

2-4-6-2. Vertical axis

As indicated by (2) illustrated in FIG. 13, the operator terminal 20 displays the graph having the "vertical axis" that indicates the value of the sensor value of the system selected by the operator O. In the example indicated by (2) illustrated in FIG. 13, the operator terminal 20 displays each of the sensor values of "LI001", "LI002", and "LI003" corresponding to the processes performed in the plant.

2-4-6-3. Horizontal axis

As indicated by (3) illustrated in FIG. 13, the operator terminal 20 displays the graph having the "horizontal axis" that indicates time series of the system selected by the operator O. In the example indicated by (3) illustrated in FIG. 13, the operator terminal 20 displays time associated with each of "LI001", "LI002", and "LI003" corresponding to the processes performed in the plant.

2-4-6-4. Without AI control

As indicated by (4) illustrated in FIG. 13, the operator terminal 20 displays the graphs indicating the time series variations in the sensor values indicated in a case of "without AI control" that is a case where the AI control model CM is not introduced to the system selected by the operator O. In the example indicated by (4) illustrated in FIG. 13, the operator terminal 20 displays each of the time series graphs indicating the time series variations in the sensor values indicated in a case where the AI control is not performed on "LI001", "LI002", and "LI003" that are the processes performed in the plant by using broken lines.

2-4-6-5. With AI control

As indicated by (5) illustrated in FIG. 13, the operator terminal 20 displays the graphs indicating the time series variations in the sensor values indicated in a case of "with AI control" that is a case where the AI control model CM is introduced to the system selected by the operator O. In the example indicated by (5) illustrated in FIG. 13, the operator terminal 20 displays each of the time series graphs indicating the time series variations in the sensor values indicated in a case where the AI control is performed on "LI001", "LI002", and "LI003" that are the processes performed in the plant by using solid lines.

2-4-6-6. Others

The operator terminal 20 may superimpose the plurality of types of sensor values onto the time series graphs and display the result. Furthermore, the operator terminal 20 may superimpose explanatory legends, in which a type and a name of a time series graph are associated with a line type and a line color, onto the time series graph, and display the result. Furthermore, the operator terminal 20 may superimpose a "target value" that indicates the target value of the sensor value of the system selected by the operator O and "target time" that indicates a target clock time or a target period, in which the sensor value is equal to or less than the target value or equal to or greater than the target value, onto the time series graph, and display the result.

3. Flow of each process performed in effect report providing system 100

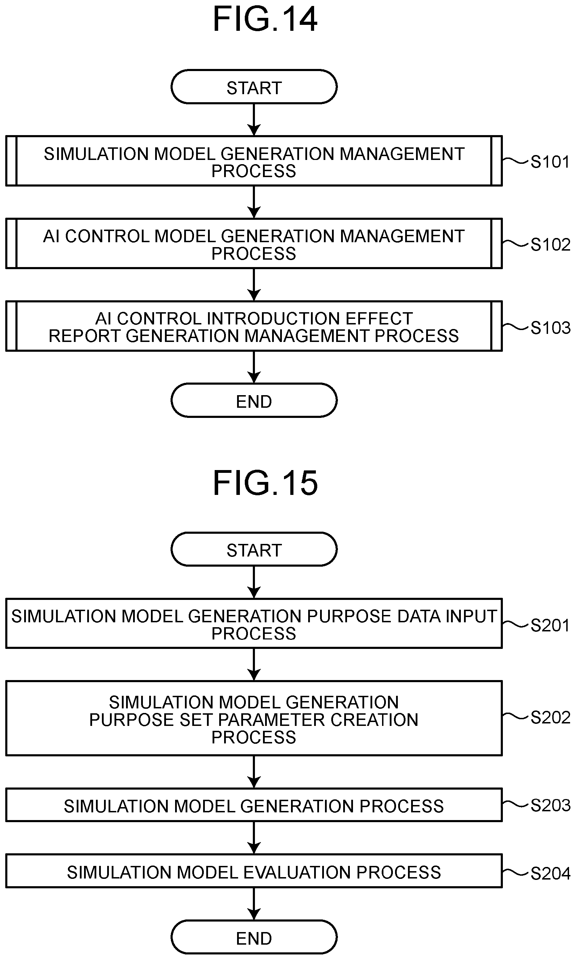

The flow of the process performed in the effect report providing system 100 according to the embodiment will be described with reference to FIG. 14 to FIG. 17. In the following, the overall flow of the process performed in the effect report providing system 100 will be described first, and then, the simulation model generation management process, the AI control model generation management process, and the AI control introduction effect report generation management process will be described as each of the processes.

3-1. Overall process performed in effect report providing system 100

The flow of the overall process performed in the effect report providing system 100 according to the embodiment will be described with reference to FIG. 14. FIG. 14 is a flowchart illustrating one example of the flow of the overall process performed in the effect report providing system 100 according to the embodiment. Furthermore, the processes performed at Steps S101 to S103 described below may be performed in different order. Furthermore, some of the processes performed at Steps S101 to S103 described below may be omitted.

3-1-1. Simulation model generation management process

At a first step, the server device 10 performs the simulation model generation management process (Step S101). For example, the server device 10 manages generation of the simulation model SM that predicts the process value of the plant by performing the processes at Steps S201 to S204 that will be described later.

3-1-2. AI control model generation management process

At a second step, the server device 10 performs AI control model generation management process (Step S102). For example, the server device 10 manages generation of the AI control model CM that controls the process value of the plant by performing the process performed at Steps S301 to S304 that will be described later.

3-1-3. AI control introduction effect report generation management process

At a third step, the server device 10 performs the AI control introduction effect report generation management process (Step S103), and ends the process. For example, the server device 10 manages generation of the AI control introduction effect report that is used to verify the effect of the introduction of the AI control model CM by performing the process at Steps S401 to S403 that will be described later.

3-2. Simulation model generation management process

The flow of the simulation model generation management process performed in the effect report providing system 100 according to the embodiment will be described with reference to FIG. 15. FIG. 15 is a flowchart illustrating one example of the flow of the simulation model generation management process performed in the effect report providing system 100 according to the embodiment. Moreover, the processes performed at Steps S201 to S204 described below may be performed in different order. Furthermore, some of the processes performed at Steps S201 to S204 described below may be omitted.

3-2-1. Simulation model generation purpose data input process

At a first step, the server device 10 performs the simulation model generation purpose data input process (Step S201). For example, the operator O transmits the training data, the evaluation data, and the simulation model input/output definition information that are input to the simulation model SM stored in the operator terminal 20 to the server device 10 by operating the operator terminal 20.

3-2-2. Simulation model generation purpose set parameter creation process

At a second step, the server device 10 performs the simulation model generation purpose set parameter creation process (Step S202). For example, the server device 10 generates the N patterns of the simulation model generation purpose set parameters on the basis of the grid search.

3-2-3. Simulation model generation process

At a third step, the server device 10 performs the simulation model generation process (Step S203). For example, the server device 10 inputs the training data, the simulation model generation purpose set parameter, and the simulation model generation purpose input/output definition information to the simulation model SM, and generates the N simulation models SM.

3-2-4. Simulation model evaluation process

At a fourth step, the server device 10 performs the simulation model evaluation process (Step S204), and ends the simulation model generation management process. For example, the server device 10 calculates the simulation model evaluation value by inputting the evaluation data to the simulation model SM, and determines the best simulation model SM (Best) indicating the best performance from among the N simulation models SM.

3-3. AI control model generation management process

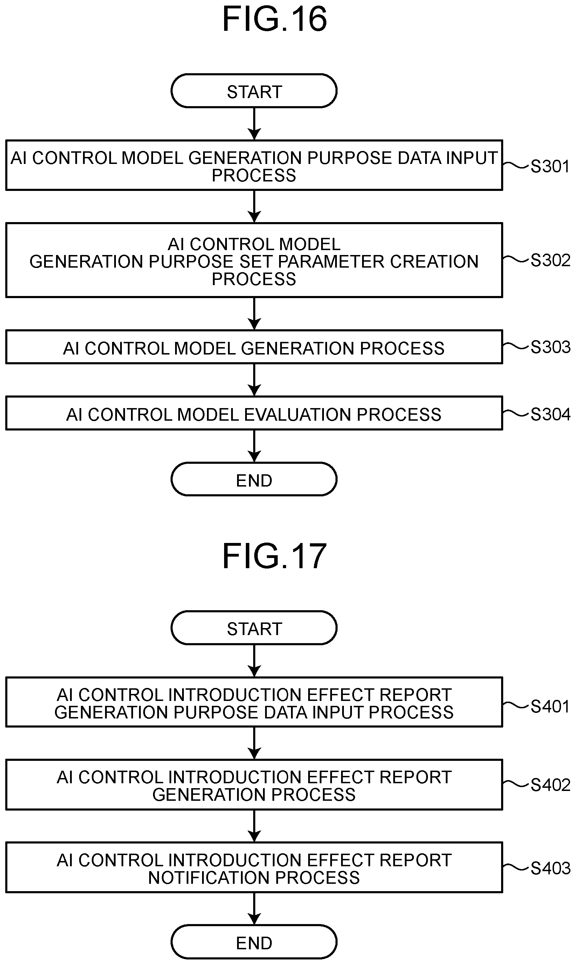

The flow of the AI control model generation management process performed in the effect report providing system 100 according to the embodiment will be described with reference to FIG. 16. FIG. 16 is a flowchart illustrating one example of the flow of the AI control model generation management process performed in the effect report providing system 100 according to the embodiment. Moreover, the processes performed at Steps S301 to S304 described below may be performed in different order. Furthermore, some of the processes performed at Steps S301 to S304 described below may be omitted.

3-3-1. AI control model generation purpose data input process

At a first step, the server device 10 performs the AI control model generation purpose data input process (Step S301). For example, the operator O transmits the training data, the evaluation data, and the AI control model input/output definition information that are input to the AI control model CM stored in the operator terminal 20 to the server device 10 by operating the operator terminal 20.

3-3-2. AI control model generation purpose set parameter creation process

At a second step, the server device 10 performs the AI control model generation purpose set parameter creation process (Step S302). The server device 10 generates the M patterns of the AI control model generation purpose set parameters on the basis of the grid search.

3-3-3. AI control model generation process

At a third step, the server device 10 performs AI control model generation process (Step S303). For example, the server device 10 inputs the training data, the AI control model generation purpose set parameter, and the AI control model generation purpose input/output definition information to the AI control model CM in the actual environment of the best simulation model SM (Best), and generates the M AI control models CM.

3-3-4. AI control model evaluation process

At a fourth step, the server device 10 performs the AI control model evaluation process (Step S304), and ends the AI control model generation management process. For example, the server device 10 calculates the AI control model evaluation value by inputting the evaluation data to the AI control model CM, and determines the best AI control model CM (Best) indicating the best performance from among the M AI control models CM.

3-4. AI control introduction effect report generation management process

The flow of the AI control introduction effect report generation management process performed in the effect report providing system 100 according to the embodiment will be described with reference to FIG. 17. FIG. 17 is a flowchart illustrating one example of the flow of the AI control introduction effect report generation management process performed in the effect report providing system 100 according to the embodiment. Moreover, the processes performed at Steps S401 to S403 described below may be performed in different order. Furthermore, some of the processes performed at Steps S401 to S403 described below may be omitted.

3-4-1. AI control introduction effect report generation purpose data input process

At a first step, the server device 10 performs the AI control introduction effect report generation purpose data input process (Step S401). For example, the operator O transmits the evaluation data that is used to generate the AI control introduction effect report stored in the operator terminal 20 to the server device 10 by operating the operator terminal 20.

3-4-2. AI control introduction effect report generation process

At a second step, the server device 10 performs the AI control introduction effect report generation process (Step S402). For example, the server device 10 generates the sensor value to be indicated in a case where the AI control is not performed by inputting the evaluation data to best simulation model SM (Best), generates the sensor value to be indicated in a case where the AI control by inputting the control data output from the best AI control model CM (Best) to the best simulation model SM (Best), and generates the AI control introduction effect report in which the bar graphs or the time series graphs are able to be compared.

3-4-3. AI control introduction effect report notification process

At a third step, the server device 10 performs the AI control introduction effect report notification process (Step S403), and ends the process. For example, the server device 10 transmits the generated AI control introduction effect report to the operator terminal 20, and causes the bar graphs or the time series graphs to be displayed on the monitor of the operator terminal 20.

4. Effect of embodiment

The effects of the embodiment will be described. In the following, a first to a ninth effects corresponding to the processes according to embodiment will be described.

4-1. First effect

As a first effect, in the process according to the above described embodiment, the server device 10 generates, on the basis of the pieces of operational data collected from the system, the N simulation models SM each of which outputs prediction data on the operational status of the system in accordance with an input of the operational data; determines, on the basis of the operational data, the best simulation model SM (Best) in which the simulation model evaluation value for evaluating the simulation model SM is the maximum value; generates, on the basis of the operational data and the best simulation model SM (Best), the M AI control models CM each of which outputs the control data related to control of the system in accordance with an input of the operational data; and determines, on the basis of the operational data, the best AI control model CM (Best) in which the AI control model evaluation value for evaluating the AI control model CM is the maximum value. As a result of this, in this process, it is possible to easily verify the effect of the AI control to be introduced to the system.

4-2. Second effect

As a second effect, in the process according to the above described embodiment, the server device 10 generates, on the basis of the operational data, the best simulation model SM (Best), and the best AI control model CM (Best), the AI control introduction effect report that indicates the effect obtained in a case where the best AI control model CM (Best) is introduced to the system. As a result of this, in this process, it is possible to easily verify the effect of the AI control to be introduced to the system by generating the AI control introduction effect report.

4-3. Third effect

As a third effect, in the process according to the above described embodiment, the server device 10 generates the N simulation models SM by using, for the training data, the data set of the sensor value that indicates the state of the process performed in the system and the operation value that indicates the operation performed on the process as the operational data; using the N patterns hyperparameters generated on the basis of the grid search as the N patterns of simulation model generation purpose set parameters; and further using the simulation model generation purpose input/output definition information that defines an input/output signal to or from the simulation model SM. As a result of this, in this process, it is possible to easily verify the effect of the AI control to be introduced to the system because the operator O is able to easily train the simulation model SM.

4-4. Fourth effect

As a fourth effect, in the process according to the above described embodiment, the server device 10 uses, for the evaluation data, the data set of the sensor value that indicates the state of the process performed in the system and the operation value that indicates the process performed on the process as the operational data; calculates, as the simulation model evaluation value, a match rate between the sensor value collected from the system and the sensor value output as the prediction data; and determines the best simulation model SM (Best) in which the calculated match rate is the highest from among the generated N simulation models SM. As a result of this, in this process, it is possible to easily verify the effect of the AI control to be introduced to the system because the operator O is able to easily evaluate the simulation model SM.

4-5. Fifth effect

As a fifth effect, in the process according to the above described embodiment, the server device 10 generates the M AI control models CM by using, for the training data, the data set of the sensor value that indicates the state of the process performed in the system and the operation value that indicates the operation performed on the process as the operational data; using, as the M patterns of AI control model generation purpose set parameters, the M patterns of hyperparameters generated on the basis of the grid search; further using the AI control model generation purpose input/output definition information that defines an input/output signal to or from the AI control model CM; and using the best simulation model SM (Best). As a result of this, in this process, it is possible to easily verify the effect of the AI control to be introduced to the system because the operator O is able to easily train the AI control model CM.

4-6. Sixth effect

As a sixth effect, in the process according to the above described embodiment, the server device 10 uses, for the evaluation data, the data set of the sensor value that indicates the process performed in the system and the operation value that indicates the operation performed on the process as the operational data; calculates, as the AI control model evaluation value, the average value of the reward values in a case where the system is controlled by using the reward function; and determines the best AI control model CM (Best) in which the calculated average value of the reward values is the maximum value from among the generated M AI control models CM. As a result of this, in this process, it is possible to easily verify the effect of the AI control to be introduced to the system because the operator O is able to easily evaluate the AI control model CM.

### 4-7. Seventh effect

As a seventh effect, in the process according to the above described embodiment, the server device 10 generates the AI control introduction effect report that displays the graph in which the average value and the standard deviation of the sensor values each of which indicates the state of the process output by inputting the operation value that indicates the operation performed on the process in the system as the operational data to the best simulation model SM (Best) is able to be compared with the average value and the standard deviation of the sensor values each of which has been output by inputting the control data output by the AI control model CM to best simulation model SM (Best). As a result of this, in this process, it is possible to easily verify the effect of the AI control to be introduced to the system because the operator O is able to easily verify the effect of the introduction of the AI control model CM on the basis of statistical data.

### 4-8. Eighth effect

As an eighth effect, in the process according to the above described embodiment, the server device 10 generates the AI control introduction effect report that displays the graph in which the time series variation in the sensor values each of which indicates the state of the process output by inputting the operation value that indicates the operation performed on the process in the system as the operational data to the best simulation model SM (Best) is able to be compared with the time series variation in the sensor values each of which has been output by inputting the control data output by the AI control model CM to the best simulation model SM (Best). As a result of this, in this process, it is possible to easily verify the effect of the AI control to be introduced to the system because the operator O is able to easily verify the effect of the introduction of the AI control model CM on the basis of the time series data.

### 4-9. Ninth effect

As a ninth effect, in the process according to the above described embodiment, the system is a plant. As a result of this, in this process, it is possible to easily verify the effect of the AI control to be introduced to the system because the operator O is able to easily verify the effect of the introduction of the AI control model CM to the plant.

### 5. Application example according to embodiment

An application example according to the embodiment will be described. In the following, a first application example and a second application example according to the embodiment will be described.

### 5-1. First application example

In the effect report providing system 100, the server device 10 is able to adjust dynamic process control. For example, the server device 10 is able to generate the AI control model CM suitable for a case of variation in manufacturing process by collecting pieces of operation data on the plant site in real time and continuously training the AI control model CM. In other words, the server device 10 is able to generate the AI control model CM capable of maintaining optimum control at the time of rapid demand fluctuation or a change in quality of a material, and is able to immediately confirm the introduction effect.

### 5-2. Second application example

In the effect report providing system 100, the server device 10 is able to generate the AI control introduction effect report on the overall Key Performance Indicator (KPI) value of the plant. For example, the server device 10 is able to generate an effective AI control model CM for optimizing the overall performance in the plant by utilizing the overall KPI value (e.g.: production efficiency or efficiency of energy usage) in the plant as the training data and the evaluation data. At this time, the server device 10 is able to visualize a change in the KPI and a degree of improvement before and after the introduction of the AI control by using the generated AI control introduction effect report.

6. System

The flow of the processes, the control procedures, the specific names, and the information containing various kinds of data or parameters indicated in the above specification and drawings can be arbitrarily changed unless otherwise stated.

Furthermore, the components of each unit illustrated in the drawings are only for conceptually illustrating the functions thereof and are not always physically configured as illustrated in the drawings. In other words, the specific shape of a separate or integrated device is not limited to the drawings. Specifically, all or part of the device can be configured by functionally or physically separating or integrating any of the units depending on various loads or use conditions.

Furthermore, all or any part of each of the processing functions performed by each of the devices can be implemented by a CPU and by programs analyzed and executed by the CPU or implemented as hardware by wired logic.

7. Hardware

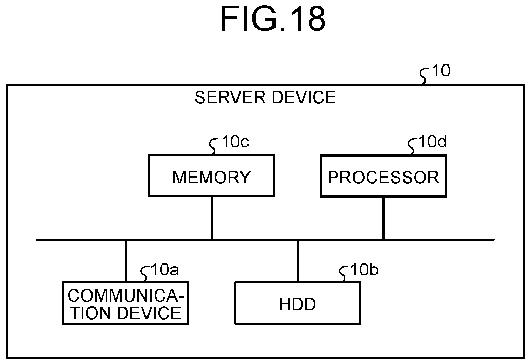

In the following, an example of a hardware configuration of the server device 10 that is an information providing apparatus will be described. Furthermore, the other devices may also have a similar hardware configuration. FIG. 18 is a diagram illustrating an example of a hardware configuration according to the embodiment. As illustrated in FIG. 18, the server device 10 includes a communication device 10a, a hard disk drive (HDD) 10b, a memory 10c, and a processor 10d. Moreover, each of the units illustrated in FIG. 18 is connected by a bus or the like with each other.

The communication device 10a is a network interface card or the like, and performs communication with another server. The HDD 10b stores therein a database and a program that causes the functions illustrated in FIG. 2 to operate.

The processor 10d operates the process that executes each of the functions described above in FIG. 2 or the like by reading the program that executes the same processes as those performed by each of the processing units illustrated in FIG. 2 from the HDD 10b or the like and loading the read program in the memory 10c. For example, the process executes the same functions as those performed by each of the processing units included in the server device 10. Specifically, the processor 10d reads, from the HDD 10b or the like, the program having the same functions as those performed by the first acquisition unit 15a, the first adjustment unit 15b, the first generation unit 15c, the first evaluation unit 15d, the second acquisition unit 15e, the second adjustment unit 15f, the second generation unit 15g, the second evaluation unit 15h, the third acquisition unit 15i, the third generation unit 15j, the notification unit 15k, and the like. Then, the processor 10d executes the same processes as those performed by the first acquisition unit 15a, the first adjustment unit 15b, the first generation unit 15c, the first evaluation unit 15d, the second acquisition unit 15e, the second adjustment unit 15f, the second generation unit 15g, the second evaluation unit 15h, the third acquisition unit 15i, the third generation unit 15j, the notification unit 15k, and the like.

In this way, the server device 10 operates as a device that executes various processing methods by reading and executing the program. Furthermore, the server device 10 is also able to implement the same functions as those described above in the embodiment by reading the above described program from a recording medium by a medium reading device and executing the read program. In addition, the program described in this embodiment need not always be executed by the server device 10. For example, the present invention may also be similarly applied to a case in which another computer or another server executes the program or in a case in which another computer and another server cooperatively execute the program with each other.

The program may be distributed via a network, such as the Internet. Furthermore, the program may be executed by being recorded in a computer readable medium, such as a hard disk, a flexible disk (FD), a CD-ROM, a magneto-optical disk (MO), or a digital versatile disk (DVD), and being read from the recording medium by the computer.

According to the present invention, an advantage is provided in that it is possible to easily verify the effect of AI control that is to be introduced to a system.

**Claims**

1.  An information providing apparatus (10) comprising:

a first generation unit (15c) that generates, based on operational data collected from a system, a plurality of first models each of which outputs prediction data on an operational status of the system in accordance with an input of the operational data;
a first evaluation unit (15d) that determines, based on the operational data, the first model in which a first evaluation value for evaluating the first model is a maximum value;
a second generation unit (15g) that generates, based on the operational data and the determined first model, a plurality of second models each of which outputs control data related to control of the system in accordance with an input of the operational data; and

a second evaluation unit (15h) that determines, based on the operational data, the second model in which a second evaluation value for evaluating the second model is a maximum value.

2. The information providing apparatus (10) according to claim 1, further comprising a third generation unit (15j) that generates, based on the operational data, the determined first model, and the determined second model, an effect report that indicates an effect obtained in a case where the second model is introduced to the system.

3. The information providing apparatus (10) according to claim 1 or 2, wherein
   the first generation unit (15c) generates the plurality of first models

   by using, for training data, a data set of a sensor value that indicates a state of a process performed in the system and an operation value that indicates an operation performed on the process as the operational data,
   by using a plurality of hyperparameters that are generated based on a grid search, and
   by further using first definition information that defines an input/output signal to or from the first model.

4. The information providing apparatus (10) according to any one of claims 1 to 3, wherein
   the first evaluation unit (15d)

   uses, for evaluation data, a data set of a sensor value that indicates a state of a process performed in the system and an operation value that indicates an operation performed on the process as the operational data,
   calculates, as the first evaluation value, a match rate between the sensor value collected from the system and the sensor value output as the prediction data, and
   determines the first model in which the calculated match rate is the highest from among the generated plurality of first models.

5. The information providing apparatus (10) according to any one of claims 1 to 4, wherein
   the second generation unit (15g) generates the plurality of second models

   by using, for training data, a data set of a sensor value that indicates a state of a process performed in the system and an operation value that indicates an operation performed on the process as the operational data,
   by using a plurality of hyperparameters generated based on a grid search,
   by further using second definition information that defines an input/output signal to or from the second model, and
   by using the determined first model.

6. The information providing apparatus (10) according to any one of claims 1 to 5, wherein
   the second evaluation unit (15h)

   uses, for evaluation data, a data set of a sensor value that indicates a state of a process performed in the system and an operation value that indicates an operation performed on the process as the operational data,
   calculates, as the second evaluation value, an average value of reward values in a case where the system is controlled by using a reward function, and
   determines the second model in which the calculated average value of the reward values is a maximum value from among the generated plurality of second models.

7. The information providing apparatus (10) according to any one of claims 2 to 6, wherein the third generation unit (15j) generates the effect report that displays a graph in which an average value and a standard deviation of sensor values each of which indicates a state of a process output by inputting an operation value that indicates an operation performed on the process in the system as the operational data to the determined first model is able to be compared with an average value and a standard deviation of the sensor values each of which has been output by inputting the control data output by the second model to the determined first model.

8. The information providing apparatus (10) according to any one of claims 2 to 7, wherein the third generation unit (15j) generates the effect report that displays a graph in which a time series variation in sensor values each of which indicates a state of a process output by inputting an operation value that indicates an operation performed on the process in the system as the operational data to the determined first model is able to be compared with a time series variation in the sensor values output by inputting the control data output by the second model to the determined first model.

9. The information providing apparatus (10) according to any one of claims 1 to 8, wherein the system is a plant.

10. An information providing method that causes a computer (10) to execute a process comprising:

generating, based on operational data collected from a system, a plurality of first models each of which outputs prediction data on an operational status of the system in accordance with an input of the operational data; determining, based on the operational data, the first model in which a first evaluation value for evaluating the first model is a maximum value; generating, based on the operational data and the determined first model, a plurality of second models each of which outputs control data related to control of the system in accordance with an input of the operational data; and determining, based on the operational data, the second model in which a second evaluation value for evaluating the second model is a maximum value.

11. An information providing program that causes a computer (10) to execute a process comprising:

generating, based on operational data collected from a system, a plurality of first models each of which outputs prediction data on an operational status of the system in accordance with an input of the operational data; determining, based on the operational data, the first model in which a first evaluation value for evaluating the first model is a maximum value; generating, based on the operational data and the determined first model, a plurality of second models each of which outputs control data related to control of the system in accordance with an input of the operational data; and determining, based on the operational data, the second model in which a second evaluation value for evaluating the second model is a maximum value.

# FIG.1

OPERATOR

OPERATOR TERMINAL — 20

INPUT SIMULATION MODEL GENERATION PURPOSE DATA
S1

INPUT AI CONTROL MODEL GENERATION PURPOSE DATA
S5

S9
INPUT EFFECT REPORT GENERATION PURPOSE DATA

S11
NOTIFY EFFECT REPORT

SERVER DEVICE — 10

100

S4 EVALUATE SIMULATION MODEL

S3 GENERATE SIMULATION MODE

S2 GENERATE SET PARAMETER FOR GENERATING SIMULATION MODEL

S10 GENERATE EFFECT REPORT

S6 GENERATE SET PARAMETER FOR GENERATING AI CONTROL MODEL

S7 GENERATE AI CONTROL MODEL

S8 EVALUATE AI CONTROL MODEL

EP 4 610 747 A1

# FIG.2

**100**

**20 OPERATOR TERMINAL**
- **21** INPUT/OUTPUT UNIT
- **22** TRANSMISSION/RECEPTION UNIT
- **23** COMMUNICATION UNIT
- **24** STORAGE UNIT
  - **24a** TRAINING DATA STORAGE UNIT
  - **24b** EVALUATION DATA STORAGE UNIT
  - **24c** DEFINITION INFORMATION STORAGE UNIT

N

**10 SERVER DEVICE**

- **11** INPUT UNIT
- **12** OUTPUT UNIT
- **13** COMMUNICATION UNIT

**15 CONTROL UNIT**
- **15a** FIRST ACQUISITION UNIT
- **15b** FIRST ADJUSTMENT UNIT
- **15c** FIRST GENERATION UNIT
- **15d** FIRST EVALUATION UNIT
- **15e** SECOND ACQUISITION UNIT
- **15f** SECOND ADJUSTMENT UNIT
- **15g** SECOND GENERATION UNIT
- **15h** SECOND EVALUATION UNIT
- **15i** THIRD ACQUISITION UNIT
- **15j** THIRD GENERATION UNIT
- **15k** NOTIFICATION UNIT

**14 STORAGE UNIT**
- **14a** FIRST SET VALUE STORAGE UNIT
- **14b** FIRST MODEL STORAGE UNIT
- **14c** SECOND SET VALUE STORAGE UNIT
- **14d** SECOND MODEL STORAGE UNIT
- **14e** EFFECT REPORT STORAGE UNIT

FIG.3

SIMULATION MODEL GENERATION MANAGEMENT PROCESS

~10

TRAINING DATA EVALUATION DATA INPUT/OUTPUT DEFINITION INFORMATION

INPUT → FIRST ACQUISITION UNIT (15a) → INPUT → FIRST GENERATION UNIT (15c) → READ PARAMETER → FIRST ADJUSTMENT UNIT (15b) → READ PARAMETER → FIRST SET VALUE STORAGE UNIT (14a)

OUTPUT MODEL

INPUT → FIRST EVALUATION UNIT (15d) → EVALUATE MODEL → FIRST MODEL STORAGE UNIT (14b)

AI CONTROL MODEL GENERATION MANAGEMENT PROCESS

USE MODEL

TRAINING DATA EVALUATION DATA INPUT/OUTPUT DEFINITION INFORMATION

INPUT → SECOND ACQUISITION UNIT (15e) → INPUT → SECOND GENERATION UNIT (15g) → READ PARAMETER → SECOND ADJUSTMENT UNIT (15f) → READ PARAMETER → SECOND SET VALUE STORAGE UNIT (14c)

OUTPUT MODEL

INPUT → SECOND EVALUATION UNIT (15h) → EVALUATE MODEL → SECOND MODEL STORAGE UNIT (14d)

AI CONTROL INTRODUCTION EFFECT REPORT GENERATION MANAGEMENT PROCESS

USE MODEL

EVALUATION DATA

INPUT → THIRD ACQUISITION UNIT (15i) → INPUT → THIRD GENERATION UNIT (15j) → OUTPUT REPORT → EFFECT REPORT STORAGE UNIT (14e) → ACQUIRE REPORT → NOTIFICATION UNIT (15k) → NOTIFY REPORT → AI CONTROL INTRODUCTION EFFECT REPORT

EP 4 610 747 A1

31

# FIG.4

14a

| SIMULATION MODEL | SET PARAMETER |
|---|---|
| SIMULATION MODEL SM-1 | SET PARAMETER SMP-1-1 |
| | SET PARAMETER SMP-1-2 |
| | SET PARAMETER SMP-1-3 |
| | ... |
| | SET PARAMETER SMP-1-N |

# FIG.5

14b

| SIMULATION MODEL | SCORE |
|---|---|
| SIMULATION MODEL SM-1-1 | SCORE SM-1-1 |
| SIMULATION MODEL SM-1-2 | SCORE SM-1-2 |
| SIMULATION MODEL SM-1-3 | SCORE SM-1-3 |
| ... | ... |
| SIMULATION MODEL SM-1-N | SCORE SM-1-N |

# FIG.6

14c

| AI CONTROL MODEL | SET PARAMETER |
|---|---|
| AI CONTROL MODEL CM-1 | SET PARAMETER CMP-1-1 |
| | SET PARAMETER CMP-1-2 |
| | SET PARAMETER CMP-1-3 |
| | ... |
| | SET PARAMETER CMP-1-M |

# FIG.7

14d

| AI CONTROL MODEL | SCORE |
|---|---|
| AI CONTROL MODEL CM-1-1 | SCORE CM-1-1 |
| AI CONTROL MODEL CM-1-2 | SCORE CM-1-2 |
| AI CONTROL MODEL CM-1-3 | SCORE CM-1-3 |
| ... | ... |
| AI CONTROL MODEL CM-1-M | SCORE CM-1-N |

# FIG.8

14e

| PLANT | EFFECT REPORT | ... |
|-------|---------------|-----|
| PLANT #1 | EFFECT REPORT #1 | ... |

# FIG.9

24a

| PLANT | EVALUATION DATA | ... |
|-------|-----------------|-----|
| PLANT #1 | EVALUATION DATA #1 | ... |

# FIG.10

24b

| PLANT | EVALUATION DATA | ... |
|---|---|---|
| PLANT #1 | EVALUATION DATA #1 | ... |

# FIG.11

24c

| PLANT | DEFINITION INFORMATION 1 | DEFINITION INFORMATION 2 | ... |
|---|---|---|---|
| PLANT #1 | DEFINITION INFORMATION #1-1 | DEFINITION INFORMATION #1-2 | ... |

# FIG.12

(2) VERTICAL AXIS: SENSOR VALUE

LI001

(1) SELECTION TAG

STANDARD DEVIATION

AVERAGE VALUE

(5)

TARGET VALUE

(3) WITHOUT AI CONTROL

(4) WITH AI CONTROL

EP 4 610 747 A1

# FIG.13

(1) SELECTION TAG

(2) VERTICAL AXIS: SENSOR VALUE

(4) WITHOUT AI CONTROL

(5) WITH AI CONTROL

(3) HORIZONTAL AXIS: TIME

# FIG.14

```
           ┌─────────────┐
           │    START    │
           └─────────────┘
                  │
                  ▼
┌──────────────────────────────────────────┐
│  SIMULATION MODEL GENERATION MANAGEMENT   │  ～S101
│                PROCESS                     │
└──────────────────────────────────────────┘
                  │
                  ▼
┌──────────────────────────────────────────┐
│  AI CONTROL MODEL GENERATION MANAGEMENT   │  ～S102
│                PROCESS                     │
└──────────────────────────────────────────┘
                  │
                  ▼
┌──────────────────────────────────────────┐
│      AI CONTROL INTRODUCTION EFFECT        │  ～S103
│  REPORT GENERATION MANAGEMENT PROCESS      │
└──────────────────────────────────────────┘
                  │
                  ▼
           ┌─────────────┐
           │     END     │
           └─────────────┘
```

# FIG.15

```
           ┌─────────────┐
           │    START    │
           └─────────────┘
                  │
                  ▼
┌──────────────────────────────────────────┐
│ SIMULATION MODEL GENERATION PURPOSE DATA   │  ～S201
│           INPUT PROCESS                    │
└──────────────────────────────────────────┘
                  │
                  ▼
┌──────────────────────────────────────────┐
│      SIMULATION MODEL GENERATION           │
│   PURPOSE SET PARAMETER CREATION           │  ～S202
│                PROCESS                     │
└──────────────────────────────────────────┘
                  │
                  ▼
┌──────────────────────────────────────────┐
│   SIMULATION MODEL GENERATION PROCESS      │  ～S203
└──────────────────────────────────────────┘
                  │
                  ▼
┌──────────────────────────────────────────┐
│   SIMULATION MODEL EVALUATION PROCESS      │  ～S204
└──────────────────────────────────────────┘
                  │
                  ▼
           ┌─────────────┐
           │     END     │
           └─────────────┘
```

# FIG.16

```
                    START

AI CONTROL MODEL GENERATION PURPOSE DATA INPUT        S301
                 PROCESS

              AI CONTROL MODEL
GENERATION PURPOSE SET PARAMETER CREATION            S302
                 PROCESS

     AI CONTROL MODEL GENERATION PROCESS             S303

       AI CONTROL MODEL EVALUATION PROCESS           S304

                     END
```

# FIG.17

```
                    START

   AI CONTROL INTRODUCTION EFFECT REPORT             S401
   GENERATION PURPOSE DATA INPUT PROCESS

   AI CONTROL INTRODUCTION EFFECT REPORT             S402
           GENERATION PROCESS

   AI CONTROL INTRODUCTION EFFECT REPORT             S403
          NOTIFICATION PROCESS

                     END
```

# FIG.18

```
                                                       ⌇10
┌────────────────────────────────────────────────────────┐
│                    SERVER DEVICE                        │
│                                                         │
│            ⌇10c                      ⌇10d               │
│     ┌──────────────┐         ┌──────────────┐           │
│     │    MEMORY     │         │  PROCESSOR   │           │
│     └──────┬───────┘         └──────┬───────┘           │
│            │                        │                   │
│    ────────┴────────────────────────┴──────────         │
│        │                    │                           │
│       ⌇10a                 ⌇10b                          │
│  ┌──────────────┐    ┌──────────────┐                   │
│  │ COMMUNICA-   │    │     HDD      │                   │
│  │ TION DEVICE  │    │              │                   │
│  └──────────────┘    └──────────────┘                   │
└────────────────────────────────────────────────────────┘
```

| | Europäisches Patentamt European Patent Office Office européen des brevets | **EUROPEAN SEARCH REPORT** | **Application Number** EP 25 15 9118 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | EP 3 200 038 A1 (NEC CORP [JP]) 2 August 2017 (2017-08-02) * paragraph [0028] - paragraph [0104] * ----- | 1-11 | INV. G05B13/02 G05B17/02 |
| Y | EP 4 283 412 A1 (YOKOGAWA ELECTRIC CORP [JP]) 29 November 2023 (2023-11-29) * paragraph [0013] - paragraph [0059] * ----- | 1-11 | |
| A | US 2023/367927 A1 (NAKANO SHOTA [JP]) 16 November 2023 (2023-11-16) * paragraph [0026] - paragraph [0070] * * figure 5 * ----- | 1-11 | |
| A | US 2023/228446 A1 (LEE ZACHARY [US] ET AL) 20 July 2023 (2023-07-20) * paragraph [0045] - paragraph [0290] * * figures 2, 10 * ----- | 1-11 | |

| | TECHNICAL FIELDS SEARCHED (IPC) |
|---|---|
| | G05B |

The present search report has been drawn up for all claims

| Place of search | Date of completion of the search | Examiner |
|---|---|---|
| The Hague | 24 June 2025 | Zake, Zane |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 610 747 A1**

## ANNEX TO THE EUROPEAN SEARCH REPORT
## ON EUROPEAN PATENT APPLICATION NO.

EP 25 15 9118

24-06-2025

| Patent document cited in search report | | Publication date | Patent family member(s) | | Publication date |
|---|---|---|---|---|---|
| EP 3200038 | A1 | 02-08-2017 | EP | 3200038 A1 | 02-08-2017 |
| | | | JP | WO2016047118 A1 | 06-07-2017 |
| | | | WO | 2016047118 A1 | 31-03-2016 |
| EP 4283412 | A1 | 29-11-2023 | CN | 117131339 A | 28-11-2023 |
| | | | EP | 4283412 A1 | 29-11-2023 |
| | | | JP | 2023173459 A | 07-12-2023 |
| | | | US | 2023384742 A1 | 30-11-2023 |
| US 2023367927 | A1 | 16-11-2023 | CN | 116724276 A | 08-09-2023 |
| | | | DE | 112021005796 T5 | 21-09-2023 |
| | | | JP | 7123267 B1 | 22-08-2022 |
| | | | JP | WO2022195825 A1 | 22-09-2022 |
| | | | US | 2023367927 A1 | 16-11-2023 |
| | | | WO | 2022195825 A1 | 22-09-2022 |
| US 2023228446 | A1 | 20-07-2023 | NONE | | |

**REFERENCES CITED IN THE DESCRIPTION**

**Patent documents cited in the description**

- JP 2023042919 A